# EUROPÄISCHE PATENTSCHRIFT

(11) **EP 3 819 647 B1**
(45) Veröffentlichungstag und Bekanntmachung des Hinweises auf die Patenterteilung: **31.12.2025**
(21) Anmeldenummer: 20205315.3
(22) Anmeldetag: 03.11.2020
(51) Int. Cl.: G01R 1/04, G01R 31/28

(54) **VERSCHLIESSBARES GRUNDMODUL FÜR EIN MODULARES TESTSYSTEM ZUM TESTEN ELEKTRISCHER BAUGRUPPEN**
LOCKABLE BASE MODULE FOR MODULAR TEST SYSTEM FOR TESTING ELECTRICAL ASSEMBLIES
MODULE DE BASE VERROUILLABLE POUR UN SYSTÈME DE TEST MODULAIRE PERMETTANT DE TESTER DES MODULES ÉLECTRIQUES

(30) Priorität: 08.11.2019 DE 102019007774
(43) Veröffentlichungstag der Anmeldung: 12.05.2021
(73) Patentinhaber: Yamaichi Electronics Deutschland GmbH, 85609 Aschheim-Dornach (DE)
(72) Erfinder: Quiter, Michael, 57482 Wenden (DE); Serna, Yoann, 6511 Zams (AT); Kahla, Hosni, 4000 Sousse (TN)
(74) Vertreter: Müller-Boré & Partner Patentanwälte PartG mbB

(56) Entgegenhaltungen:
- DE-A1- 102015 119 181
- DE-U1- 202011 107 409
- US-A- 4 812 754

## Beschreibung

Die Erfindung betrifft ein verschließbares Grundmodul für ein modulares Testsystem zum Testen elektrischer Baugruppen und ein modulares Testsystem zum Testen elektrischer Baugruppen.

Testsysteme bzw. Prüfadapter werden zum Testen elektrischer Baugruppen eingesetzt. Dabei ist vorgesehen, dass das Testsystem eine zu testende elektrische Baugruppe aufnimmt, um diese elektrisch zu kontaktieren. Ferner ist das Testsystem mit einer Testvorrichtung bzw. einer Prüfvorrichtung elektrisch verbunden, sodass mittels des Testsystems eine elektrische Verbindung zwischen der zu testenden elektrischen Baugruppe und der Testvorrichtung bzw. Prüfvorrichtung besteht.

Zum Testen der elektrischen Baugruppe wird mittels der Testvorrichtung eine Testroutine bzw. Prüfroutine aus- bzw. durchgeführt, wobei nach Abschluss der Testroutine, die in dem Testsystem angeordnete elektrische Baugruppe durch eine andere elektrische Baugruppe ersetzt werden kann. Anschließend kann die andere elektrische Baugruppe einem Test, beispielsweise einem Funktionstest, durch die Testvorrichtung unterzogen werden.

In der Regel sind die zu testenden elektrischen Baugruppen, beispielsweise Halbleiterbauelemente bzw. elektrische Baugruppen, die Halbleiterbauelemente aufweisen, empfindlich gegenüber mechanischen und elektrischen Einflüssen, welche die elektrische Baugruppe beschädigen können.

Daher ist es notwendig, beim Anordnen und Austauschen der zu testenden elektrischen Baugruppe in dem Testsystem, eine unsachgemäße mechanische Beanspruchung der zu testenden elektrischen Baugruppen zu vermeiden. Ferner muss die zu testende elektrische Baugruppe sachgerecht und sicher durch das Testsystem elektrisch kontaktiert werden, um eine Beschädigung der zu testenden elektrischen Baugruppe während des Tests zu vermeiden.

Ferner betrifft die DE 20 2011 107409 U1 eine Prüfvorrichtung für einen Prüfling, mit einem Gehäuse mit einem Gehäuseunterteil und einem zum Öffnen und Schließen des Gehäuses gegenüber dem Gehäuseunterteil beweglichen Gehäuseoberteil, wobei das Gehäuse einen Aufnahmeraum für den Prüfling ausbildet, in den eine Vielzahl von Kontaktstiften ragen, die im geschlossenen Zustand des Gehäuses an dem Prüfling anliegen, dadurch gekennzeichnet, dass zumindest eine Wand des Gehäuses eine Wabenstruktur aufweist.

Die US 4 812 754 A betrifft eine Vorrichtung zum Verbinden einer Leiterplatte mit einem Testsystem. Die Vorrichtung umfasst eine Tragstruktur, die ein Paar von ersten und zweiten Testköpfen in gegenüberliegender Beziehung beweglich trägt, wobei zumindest der erste Testkopf eine Vielzahl von Sonden aufweist, mit denen Testpunkte auf einer Leiterplatte kontaktiert und getestet werden. Betätigungskomponenten ermöglichen eine Bewegung der Testköpfe aus einer beabstandeten Ladeposition in eine enger beabstandete Prüfposition, in der jede der Sonden in Kontakt mit einem jeweiligen der Testpunkte gedrängt wird. Ein elektrischer Bus koppelt ein separates Prüfsystem zumindest an den ersten Prüfkopf.

Die DE 10 2015 119 181 A1 betrifft eine Prüfvorrichtung für ein eine Leiterplatte aufweisendes Prüfobjekt mit einem eine Halterung und/oder Auflage für das Prüfobjekt anbietenden ersten Träger und einem um eine bevorzugt horizontale Schwenkachse relativ zu dem ersten Träger durch manuelle Betätigung verschwenkbaren zweiten Träger.

Es ist daher Aufgabe der vorliegenden Erfindung, ein verschließbares Grundmodul für ein modulares Testsystem zum Testen elektrischer Baugruppen bereitzustellen, welches ein sicheres Anordnen und Austauschen der elektrischen Baugruppe in dem Testsystem ermöglicht. Ferner ist es Aufgabe der vorliegenden Erfindung ein modulares Testsystem zum Testen elektrischer Baugruppen bereitzustellen.

Diese Aufgabe wird durch die Gegenstände der unabhängigen Ansprüche gelöst.

Bevorzugte Ausführungsformen sind in den abhängigen Ansprüchen definiert.

Ein Aspekt betrifft ein verschließbares Grundmodul für ein modulares Testsystem zum Testen elektrischer Baugruppen, aufweisend:
- ein erstes Unterstützungsglied, welches einen Aufnahmeraum zum Aufnehmen eines Testmoduls bereitstellt, wobei an dem Testmodul eine zu testende elektrische Baugruppe anordenbar ist;
- ein relativ zu dem ersten Unterstützungsglied verschwenkbar gelagertes zweites Unterstützungsglied, welches dazu ausgebildet ist, ein Fixierungsmodul zum Fixieren der zu testenden elektrischen Baugruppe an dem Testmodul aufzunehmen;
- eine an dem ersten Unterstützungsglied verschwenkbar gelagerte Bedieneinheit, welche an dem zweiten Unterstützungsglied führbar gelagert ist,

wobei durch Verschwenken der Bedieneinheit gegenüber dem ersten Unterstützungsglied, das zweite Unterstützungslied in eine Öffnungsposition, in der die zu testende elektrische Baugruppe durch das Fixierungsmodul freigegeben ist, und in eine Verschlussposition, in der die zu testende elektrische Baugruppe durch das Fixierungsmodul an dem Testmodul fixiert ist, bewegbar ist, und
wobei das zweite Unterstützungsglied durch das Verschwenken der Bedieneinheit derart einer Bewegung von der Öffnungsposition in die Verschlussposition folgt, dass zu Beginn der Bewegung des zweiten Unterstützungsglieds, das zweite Unterstützungsglied in Bezug auf das erste Unterstützungsglied verschwenkt wird, und zum Ende der Bewegung, das zweite Unterstützungsglied linear in Richtung des ersten Unterstützungsglieds bewegt wird.

Die vorgeschlagene Lösung ermöglicht es, dass die zu testende elektrische Baugruppe in der Öffnungsposition durch einen Nutzer komfortabel ausgetauscht werden kann, da durch die verschwenkbare Anordnung des zweiten Unterstützungsglieds relativ zu dem ersten Unterstützungsglied, das Grundmodul weit geöffnet werden kann. Ferner ermöglicht der Übergang vom Verschwenken des zweiten Unterstützungsglieds in Bezug auf das erste Unterstützungsglied zum linearen Bewegen des zweiten Unterstützungsglieds in Richtung des ersten Unterstützungsglieds, dass das Fixierungsmodul die zu testende elektrische Baugruppe im Wesentlichen orthogonal in Richtung des Testmoduls drückt. Mit anderen Worten, dass lineare Bewegen des zweiten Unterstützungsglieds in Richtung des ersten Unterstützungsglieds verhindert, dass das Fixierungsmodul die zu testende elektrische Baugruppe quer zum Testmodul verschiebt. Ferner kann das Fixierungsmodul die zu testende elektrische Baugruppe gleichmäßig fixieren, sodass auf die zu testende elektrische Baugruppe homogen Kraft ausgeübt wird. Dadurch werden mechanische Beanspruchungen der zu testenden elektrischen Baugruppe verhindert. Des Weiteren wird verhindert, dass eine elektrische Kontaktierung zwischen dem Testmodul und der zu testenden elektrischen Baugruppe beeinträchtigt wird.

Dementsprechend kann das verschließbare Grundmodul beim Schließen zwei Bewegungsphasen des zweiten Unterstützungsglieds in Bezug auf das erste Unterstützungsglied aufweisen. In der ersten Bewegungsphase wird das zweite Unterstützungsglied in Bezug auf das erste Unterstützungsglied verschwenkt. Dabei ist die erste Bewegungsphase abgeschlossen, wenn das Testmodul und das Fixierungsmodul im Wesentlichen parallel zueinander ausgerichtet sind bzw. sich im Wesentlichen parallel gegenüberliegen. Zu Beginn der ersten Bewegungsphase sind das Testmodul und das Fixierungsmodul nicht parallel zueinander ausgerichtet bzw. liegen sich nicht parallel gegenüber.

An die erste Bewegungsphase schließt sich, bevorzugt unmittelbar, die zweite Bewegungsphase des zweiten Unterstützungsglieds relativ zu dem ersten Unterstützungsglied an. Durch die Anordnung des Testmoduls an dem ersten Unterstützungsglied und die Anordnung des Fixierungsmoduls an dem zweiten Unterstützungsglied, sind das Testmodul und das Fixierungsmodul zu Beginn der zweiten Bewegungsphase im Wesentlichen parallel zueinander ausgerichtet bzw. liegen sich im Wesentlichen parallel gegenüber. Beim Durchlaufen der zweiten Bewegungsphase kann vorgesehen sein, dass das zweite Unterstützungsglied linear in Richtung des ersten Unterstützungsglieds bewegt wird bis das Fixierungsmodul die zu testende elektrische Baugruppe an dem Testmodul fixiert. Mit anderen Worten, in der zweiten Bewegungsphase kann eine dem Testmodul zugewandte Seite des Fixierungsmoduls im Wesentlichen senkrecht in Richtung einer dem Fixierungsmodul zugewandten Seite des Testmoduls bewegt werden, wobei auf der dem Fixierungsmodul zugewandten Seite des Testmoduls die zu testende elektrische Baugruppe anordenbar ist und die dem Testmodul zugewandte Seite des Fixierungsmodul zum Fixieren der zu testenden elektrischen Baugruppe ausgebildet ist.

Vorzugsweise ist vorgesehen, dass in der Verschlussposition die Bedieneinheit durch das zweite Unterstützungsglied arretiert ist. Somit kann ein selbstständiges Öffnen des Grundmoduls bzw. Bewegen der Bedieneinheit, welches zu einem Öffnen des Grundmoduls führen könnte, verhindert werden. Vorzugsweise kann vorgesehen sein, dass zum Öffnen des Grundmoduls die Bedieneinheit aktiv durch einen Nutzer bewegt bzw. verschwenkt werden muss. Insbesondere ist die Bedieneinheit dazu ausgebildet, durch einen Nutzer verschwenkt zu werden.

Es ist vorgesehen, dass das zweite Unterstützungsglied eine erste Kulissenführung aufweist, in der ein erstes Nockenelement der Bedieneinheit führbar gelagert ist. Somit gibt die erste Kulissenführung und das erste Nockenelement die Bewegung des zweiten Unterstützungsglieds relativ zu dem ersten Unterstützungsglied vor, wenn die Bedieneinheit in Bezug auf das erste Unterstützungsglied verschwenkt wird. Ferner kann vorgesehen sein, dass das erste Nockenelement zum Bewegen der Bedieneinheit von der Öffnungsposition in die Verschlussposition zumindest abschnittsweise, bevorzugt vollständig, entlang der ersten Kulissenführung geführt wird.

Vorzugsweise kann das erste Nockenelement drehbar an der Bedieneinheit gelagert sein, um den benötigten Kraftaufwand zum Öffnen und Schließen des Grundmoduls zu reduzieren bzw. zum Verschwenken der Bedieneinheit zu reduzieren. Ferner kann der Verschleiß der ersten Kulissenführung und/oder des ersten Nockenelements reduziert werden.

Es ist vorgesehen, dass die erste Kulissenführung einen geschwungenen Abschnitt und einen an dem geschwungenen Abschnitt anschließenden ersten linearen Abschnitt aufweist und dass beim Bewegen des zweiten Unterstützungsglieds von der Öffnungsposition in die Verschlussposition, das erste Nockenelement den geschwungenen Abschnitt und den ersten linearen Abschnitt entlanggeführt wird.

Insbesondere bewirkt das Entlangführen des ersten Nockenelements am geschwungenen Abschnitt, dass das zweite Unterstützungsglied relativ zu dem ersten Unterstützungsglied verschwenkt wird, also die erste Bewegungsphase durchlaufen wird. Des Weiteren bewirkt das Entlangführen des ersten Nockenelements am ersten linearen Abschnitt, dass das zweite Unterstützungsglied linear in Richtung des ersten Unterstützungsglieds bewegt wird, also die zweite Bewegungsphase durchlaufen wird. Ferner bewirkt ein entgegengesetztes Entlangführen des ersten Nockenelements in der ersten Kulissenführung, d. h. das erste Nockenelement wird entlang des ersten linearen Abschnitts und anschließend entlang des geschwungenen Abschnitts geführt, eine Umkehr der Bewegung des zweiten Unterstützungsglieds.

Vorzugsweise ist der erste lineare Abschnitt derart ausgebildet, dass sich der erste lineare Abschnitt während der zweiten Bewegungsphase sich im Wesentlichen orthogonal zu dem Normalenvektor, der dem Fixierungsmodul zugewandten Seite des Testmoduls erstreckt. Mit anderen Worten, während der zweiten Bewegungsphase erstreckt sich der erste lineare Abschnitt im Wesentlichen parallel zu der dem Fixierungsmodul zugewandten Seite des Testmoduls.

Es ist ferner vorgesehen, dass die erste Kulissenführung einen an dem ersten linearen Abschnitt anschließenden zweiten linearen Abschnitt aufweist, der ausgehend von dem ersten linearen Abschnitt sich in Richtung des ersten Unterstützungsglieds erstreckt, und dass beim Bewegen des zweiten Unterstützungsglieds von der Öffnungsposition in die Verschlussposition, das erste Nockenelement den zweiten linearen Abschnitt entlanggeführt wird. Ferner kann vorgesehen sein, dass der geschwungene Abschnitt, der erste lineare Abschnitt und der zweite lineare Abschnitt der ersten Kulissenführung miteinander verbunden sind.

Insbesondere kann der zweite lineare Abschnitt gegenüber dem ersten linearen Abschnitt abgewinkelt sein. Vorzugsweise wird beim Bewegen des zweiten Unterstützungsglieds von der Öffnungsposition in die Verschlussposition, das erste Nockenelement zumindest abschnittsweise, bevorzugt vollständig, entlang des geschwungenen Abschnitts, des ersten linearen Abschnitts und des zweiten linearen Abschnitts der ersten Kulissenführung geführt.

Ferner kann vorgesehen sein, dass beim Übergang des ersten Nockenelements vom ersten linearen Abschnitt in den zweiten linearen Abschnitt, das zweite Unterstützungsglied die Bedieneinheit arretiert. Somit kann auf eine extra ausgebildete Arretierung, welche die Bedieneinheit in der Verschlussposition sichert, verzichtet werden. Zum Arretieren der Bedieneinheit durch das zweite Unterstützungsglied kann insbesondere vorgesehen sein, dass das zweite Unterstützungsglied federnd an dem ersten Unterstützungsglied gelagert ist. Beim Übergang des ersten Nockenelements vom ersten linearen Abschnitt in den zweiten linearen Abschnitt der ersten Kulissenführung bewirkt die gefederte Lagerung des zweiten Unterstützungsglieds an dem ersten Unterstützungsglied, dass das zweite Unterstützungsglied vom ersten Unterstützungsglied wegbewegt wird. Anschließend bewirkt das weitere Entlangführen des ersten Nockenelements an dem zweiten linearen Abschnitt, dass das zweite Unterstützungsglied wieder linear in Richtung des ersten Unterstützungsglieds geführt wird. Hierzu kann der zweite lineare Abschnitt sich ausgehend von dem zweiten linearen Abschnitt in Richtung des ersten Unterstützungsglieds verlaufen. Der Übergang des ersten Nockenelements von dem ersten linearen Abschnitt in den zweiten linearen Abschnitt und die gefederte Lagerung des zweiten Unterstützungsglieds an dem ersten Unterstützungsglied bewirkt somit einen Formschluss zwischen dem ersten Nockenelement und der ersten Kulissenführung, sodass die Bedieneinheit durch das zweite Unterstützungsglied arretiert wird. Dieser Formschluss kann durch eine aktive Betätigung des Bedienelements, beispielsweise durch einen Nutzer, aufgehoben werden, wodurch die Arretierung des Bedienelements durch das zweite Unterstützungsglied gelöst wird.

Es ist ferner vorgesehen, dass durch Entlangführen des ersten Nockenelements an dem ersten linearen Abschnitt und dem zweiten linearen Abschnitt, die Bedieneinheit das zweite Unterstützungsglied in der Verschlussposition arretiert.

Vorzugsweise kann vorgesehen sein, dass das zweite Unterstützungsglied an einem Aufnahmepunkt des ersten Unterstützungsglieds verschwenkbar/drehbar und gefedert angeordnet ist. Insbesondere kann vorgesehen sein, dass das zweite Unterstützungsglied mittels eines Langlochs an dem Aufnahmepunkt des ersten Unterstützungsglieds verschwenkbar in Bezug auf das erste Unterstützungsglied gelagert ist, wobei das Langloch bevorzugt ein Federelement aufweist, welches derart auf den Aufnahmepunkt wirkt, dass der Aufnahmepunkt an einem Ende des Langlochs liegt.

Bevorzugt wird der Aufnahmepunkt durch das Federelement des Langlochs während der ersten Bewegungsphase an dem einem Ende des Langlochs gehalten. Ferner verlagert sich mit dem Einsetzen der zweiten Bewegungsphase der Aufnahmepunkt in Richtung des anderen Endes des Langlochs, sodass zum Ende der zweiten Bewegungsphase der Aufnahmepunkt am anderen Ende des Langlochs liegt. Das zweite Unterstützungsglied kann somit auf vorteilhafte Weise einfach an dem Aufnahmepunkt des ersten Unterstützungsglieds federnd gelagert und verschwenkbar ausgebildet sein.

Vorzugsweise kann vorgesehen sein, dass das zweite Unterstützungsglied einen federgelagerten Anschlag aufweist, der beim Bewegen des zweiten Unterstützungsglieds von der Öffnungsposition in die Verschlussposition auf ein an dem ersten Unterstützungsglied angeordneten Auflagerpunkt geführt wird. Insbesondere kann der federgelagerte Anschlag erst mit Beginn der zweiten Bewegungsphase den Auflagerpunkt des ersten Unterstützungsglieds kontaktieren. Ferner kann der federgelagerte Anschlag eine erste Anschlagposition und eine zweite Anschlagposition aufweisen, wobei während der ersten Bewegungsphase der federgelagerte Anschlag die erste Anschlagposition aufweist und während der zweiten Bewegungsphase in die zweite Anschlagposition bewegt wird. Ferner entspricht das Bewegen des federgelagerten Anschlags von der ersten Anschlagposition in die zweite Anschlagposition einem Einfedern des federgelagerten Anschlags. Insbesondere kann der federgelagerte Anschlag ein Langlochs aufweisen, in welchem ein Anschlagelement federgelagert ist und welches zwischen den beiden Enden des Langlochs bewegbar ist. Ferner können während der zweiten Bewegungsphase der federgelagerte Anschlag und die Federlagerung des zweiten Unterstützungsglieds an dem Aufnahmepunkt des ersten Unterstützungsglieds gleichmäßig betätigt werden, wodurch ein gleichmäßiges Absenken, insbesondere lineares Absenken, des zweiten Unterstützungsglieds auf das erste Unterstützungsglied erfolgt.

Vorzugsweise kann vorgesehen sein, dass beim linearen Bewegen bzw. Absenkens des zweiten Unterstützungsglieds in Richtung des ersten Unterstützungsglieds, der federgelagerte Anschlag und das Federelement des Langlochs betätigt werden.

Vorzugsweise kann ferner vorgesehen sein, dass das zweite Unterstützungsglied eine zweite Kulissenführung aufweist, in der ein zweites Nockenelement der Bedieneinheit führbar gelagert ist. Die zweite Kulissenführung kann insbesondere dazu ausgebildet sein, während einem Verschwenken der Bedieneinheit, das zweite Unterstützungsglied in Bezug auf das erste Unterstützungsglied zu stabilisieren.

Vorzugsweise kann vorgesehen sein, dass das zweite Nockenelement drehbar an der Bedieneinheit gelagert ist, wodurch der Kraftaufwand zum Verschwenken der Bedieneinheit reduziert werden kann. Ferner wird der Verschleiß der zweiten Kulissenführung und des zweiten Nockenelements reduziert.

Vorzugsweise kann vorgesehen sein, dass das erste Unterstützungsglied ein Federunterstützungselement aufweist, welches mit dem zweiten Unterstützungsglied verbunden ist, wobei das Federunterstützungselement die Bewegung des zweiten Unterstützungsglieds unterstützt. Auf vorteilhafte Weise kann somit das Verschwenken der Bedieneinheit unterstützt werden. Des Weiteren kann das Federunterstützungselement dazu ausgebildet sein, ein Absenken des zweiten Unterstützungsglieds in Richtung des ersten Unterstützungsglieds zu bremsen. Das Federunterstützungselement kann beispielsweise ein Gasdruckfederelement sein.

Vorzugsweise kann vorgesehen sein, dass die Bedieneinheit als Stanzblechbauteil oder Frästeil ausgebildet ist. Insbesondere ermöglicht das Ausbilden der Bedieneinheit als Stanzblechbauteil, dass die Bedieneinheit ein möglichst geringes Gewicht aufweist und kostengünstig hergestellt werden kann.

Ein weiterer Aspekt betrifft ein Modulares Testsystem zum Testen elektrischer Baugruppen, aufweisend:
- ein zuvor beschriebenes Grundmodul; und
- ein in dem Aufnahmeraum anordenbares Testmodul.

Vorzugsweise kann das Testsystem ein an dem zweiten Unterstützungsglied anordenbares Fixierungsmodul aufweisen. Ferner können das Grundmodul, das Testmodul und das Fixierungsmodul wie oben beschrieben ausgebildet sein.

Im Folgenden wird eine Ausführungsform der Erfindung anhand der beiliegenden Figuren näher beschrieben. Es versteht sich, dass die vorliegende Erfindung nicht auf diese Ausführungsform beschränkt ist, und dass einzelne Merkmale der Ausführungsform im Rahmen der beiliegenden Ansprüche zu weiteren Ausführungsformen kombiniert werden können.

Es zeigen:
Figur 1 eine perspektivische Ansicht eines geöffneten Zustands eines modularen Testsystems in welchem ein Testmodul angeordnet ist;
Figur 2 eine perspektivische Ansicht des modularen Testsystems im geschlossenen Zustand;
Figur 3 eine perspektivische Ansicht des modularen Testsystems ohne Testmodul;
Figur 4 eine perspektivische Ansicht des Testmoduls;
Figur 5 eine Seitenansicht des Testmoduls;
Figur 6 eine Vorderseite des modularen Testsystems;
Figuren 7 und 8 jeweils eine Seitenansicht des modularen Testsystems zur Veranschaulichung des Austauschs des Testmoduls;
Figuren 9 bis 13 jeweils eine Seitenansicht des modularen Testsystems zur Veranschaulichung des Schließens des Testsystems;
Figuren 14 und 15 einen Querschnitt des Testsystems;
Figuren 16 und 17 eine weitere Ausführungsform des modularen Testsystems.

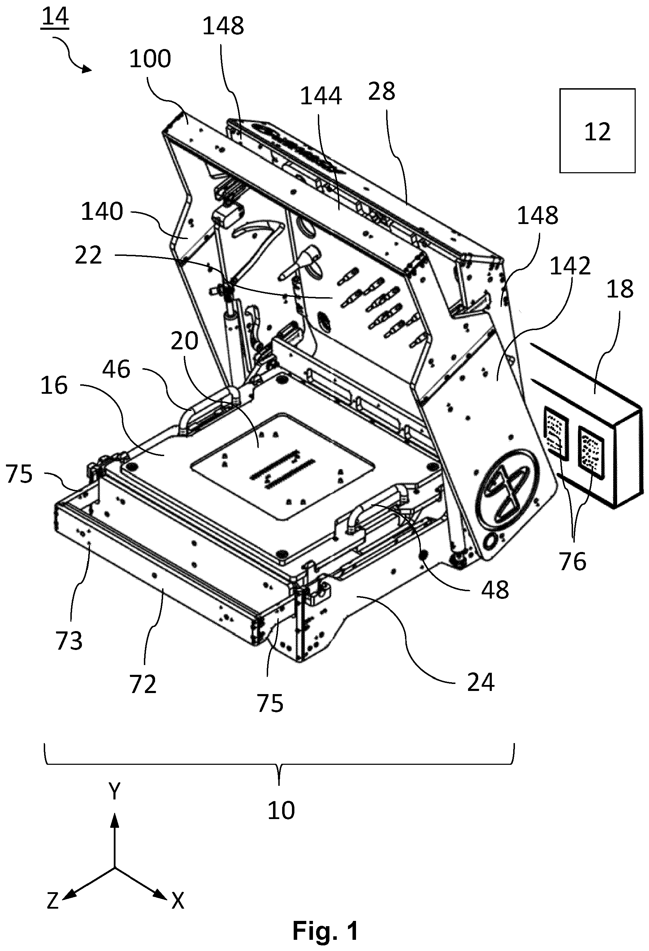

Figur 1 zeigt eine perspektivische Ansicht eines modularen Testsystems 10, welches mit einer Testvorrichtung 12 elektrisch verbindbar ist. Das modulare Testsystem 10 kann ein Grundmodul 14, ein in bzw. an dem Grundmodul 14 anordenbares Testmodul 16 und ein mit dem Grundmodul 14 verbindbares Schnittstellenmodul 18 aufweisen. Die Testvorrichtung 12 kann insbesondere elektrisch an dem Schnittstellenmodul 18 angeschlossen bzw. mit diesem verbunden werden. Ferner kann die Testvorrichtung 12 auch direkt an dem Testmodul 16 angeschlossen werden.

Figur 1 zeigt das Grundmodul 14 in einem geöffneten Zustand, in welchem das Testmodul 16 freigegeben werden kann. An dem Testmodul 16 kann ferner eine zu testende elektrische Baugruppe (nicht gezeigt) angeordnet werden.

In einer ersten Ausführungsform des Testmoduls 16, kann das Testmodul 16 einen ersten Kontaktierungsabschnitt 20 aufweisen, an dem im geöffneten Zustand des Grundmoduls 14 die zu testende elektrische Baugruppe angeordnet werden kann. Dabei ist vorgesehen, dass der erste Kontaktierungsabschnitt 20 die zu testende elektrische Baugruppe elektrisch kontaktiert.

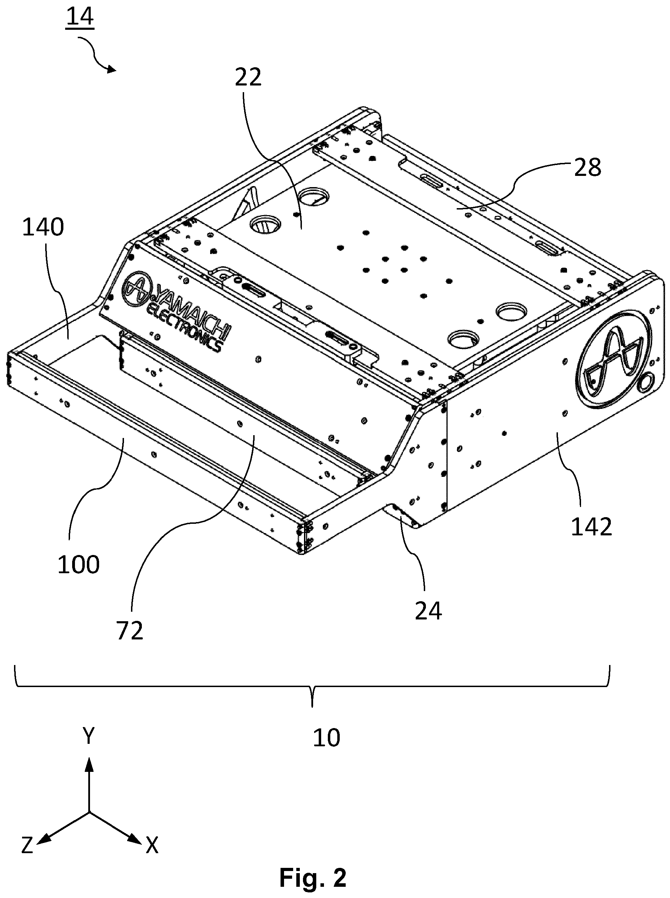

Des Weiteren weist das Grundmodul 14 ein Fixierungsmodul 22 auf, welches in dem in Figur 2 gezeigten geschlossenen Zustand des Grundmoduls 14, die zu testende elektrische Baugruppe an dem ersten Kontaktierungsabschnitt 20 fixiert.

Des Weiteren kann im geschlossenen Zustand des Grundmoduls 14, der erste Kontaktierungsabschnitt 20 dem Fixierungsmodul 22 gegenüberliegen, wobei dazwischen die zu testende elektrische Baugruppen angeordnet werden kann. Im in Figur 1 gezeigten geöffneten Zustand des Grundmoduls 14, wird die zu testende elektrische Baugruppe durch das Fixierungsmodul 22 freigegeben, sodass die elektrische Baugruppe getauscht werden kann.

Zum Testen der elektrischen Baugruppe kann vorgesehen sein, dass das Schnittstellenmodul 18 mit dem Testmodul 16 elektrisch verbunden ist, sodass die elektrische Baugruppe durch das Testmodul 16 und das Schnittstellenmodul 18 mit der Testvorrichtung 12 elektrisch verbunden ist. Es ist allerdings auch möglich, das Testmodul 16 direkt, d.h. ohne das Schnittstellenmodul 18, mit der Testvorrichtung 12 elektrisch zu verbinden, sodass das Testen der elektrischen Baugruppe auch ohne Schnittstellenmodul 18 durchgeführt werden kann.

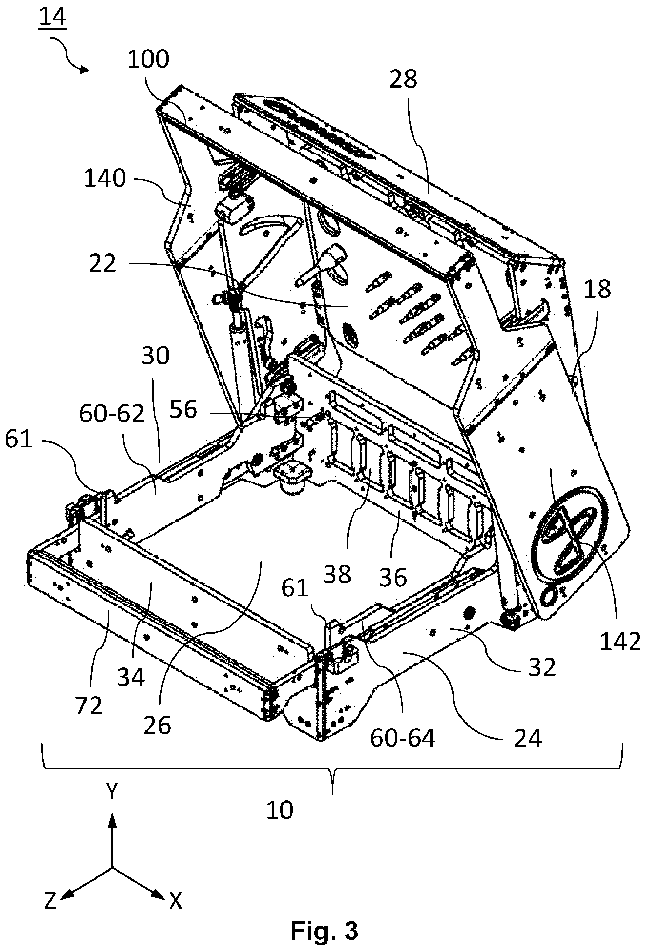

Das Grundmodul 14 weist ferner ein erstes Unterstützungsglied 24 auf, welches einen Aufnahmeraum 26 bereitstellt (siehe Figur 3), in dem das Testmodul 16 angeordnet werden kann. Des Weiteren weist das Grundmodul 14 ein zweites Unterstützungsglied 28 auf, welches relativ zu dem ersten Unterstützungsglied 24 verschwenkbar ist. Dabei ist vorgesehen, dass das Fixierungsmodul 22 lösbar mit dem zweiten Unterstützungsglied 28 verbunden ist. Durch Verschwenken des zweiten Unterstützungsglieds 28 in Bezug auf das erste Unterstützungsglied 24 kann das Grundmodul 14 geschlossen und geöffnet werden.

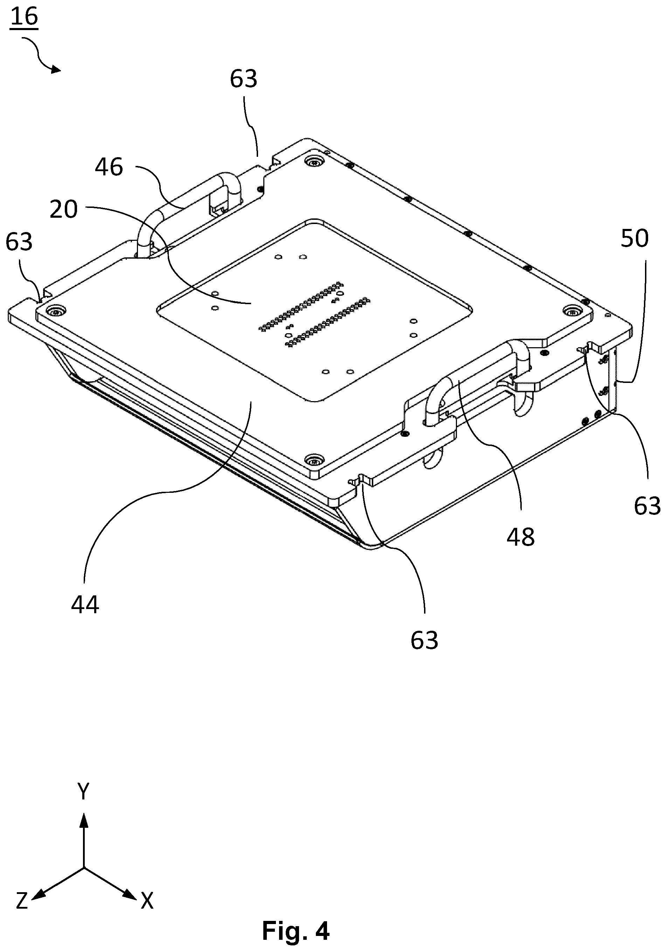

Wie in Figur 3 dargestellt, weist das erste Unterstützungsglied 24 zwei gegenüberliegend angeordnete Seitenwände 30 und 32 auf, welche an einem Ende mit einer Vorderwand 34 des ersten Unterstützungsglied 24 und an dem anderen Ende mit einer Rückwand 36 des ersten Unterstützungsglieds 24 verbunden sind. Das erste Unterstützungsglied 24 bildet somit einen im Wesentlichen rechteckig geformten Rahmen, welcher den Aufnahmeraum 26 für das Testmodul 16 bereitstellt. Im geöffneten Zustand des Grundmoduls 14 kann das in der Figur 4 gezeigte Testmodul 16 von oben in das erste Unterstützungsglied 24 eingesetzt werden bzw. aus dem ersten Unterstützungsglied 24 herausgenommen werden, um das Testmodul 16 auszutauschen. Des Weiteren ist vorgesehen, dass das erste Unterstützungsglied 24 auf einer Auflage, beispielsweise einem Tisch, anordenbar ist.

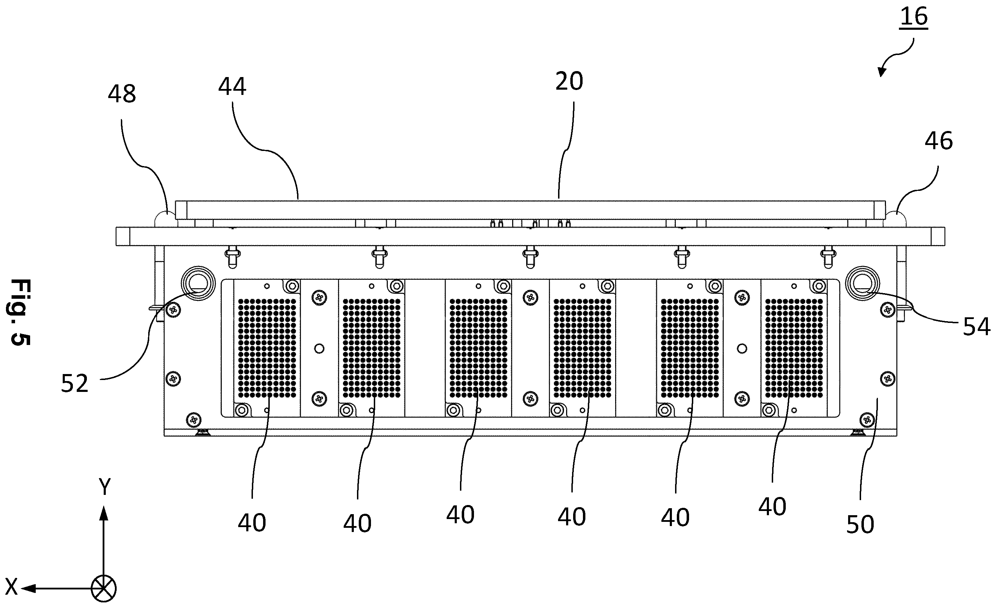

Wie in Figur 3 dargestellt, weist das erste Unterstützungsglied 24 Aussparungen 38 auf, welche in der Rückwand 36 ausgebildet sind. Die Aussparungen 38 ermöglichen es, einen zweiten Kontaktierungsabschnitt 40 (siehe Figur 5) des Testmoduls 16 mit dem Schnittstellenmodul 18 und/oder der Testvorrichtung 12 elektrisch zu verbinden.

Des Weiteren ist das Testmodul 16 beweglich in dem Grundmodul 14 gelagert, und kann relativ zu dem Grundmodul 14 bewegt werden. Insbesondere ist das Testmodul 16 linear geführt und ist zwischen der Vorderwand 34 und der Rückwand 38 hin und her bewegbar.

Figur 4 zeigt in einer perspektivischen Ansicht das Testmodul 16. Das Testmodul 16 weist ein Gehäuse 42 auf, an dessen Oberseite 44 der erste Kontaktierungsabschnitt 20 angeordnet ist. Als Oberseite 44 ist die Seite des Gehäuses 42 zu verstehen, welche im eingesetzten Zustand des Testmoduls 16 in den Aufnahmeraum 26 im Wesentlichen nach oben weist. Dabei wird davon ausgegangen, dass das Grundmodul 14 auf einer im Wesentlichen horizontal verlaufenen Auflage aufgestellt ist. Ferner ist der Oberseite 44 im geschlossenen Zustand des Grundmoduls 14 dem Fixierungsmodul 22 zugewandt. Folglich erstreckt sich die Oberseite 44 bzw. der erste Kontaktierungsabschnitt 20 im Wesentlichen horizontal. Des Weiteren weist das Testmodul 16 zwei Griffe 46 und 48 auf, mit denen das Testmodul 16 aus dem Aufnahmeraum 26 entnommen werden kann und in den Aufnahmeraum 26 eingesetzt werden kann. Die Griffe 46 und 48 sind in dem Testmodul 16 versenkbar und können auf der Oberseite 44 aus dem Testmodul 16 zumindest abschnittsweise herausbewegt werden.

Weiter ist vorgesehen, dass der zweite Kontaktierungsabschnitt 40 an einer Rückseite 50 des Testmoduls 16 angeordnet ist. Im eingesetzten Zustand des Testmoduls 16 in den Aufnahmeraum 26 ist die Rückseite 50 der Rückwand 36 zugewandt. Des Weiteren sind an der Rückseite 50 zwei voneinander beabstandete Öffnungen 52 und 54 (siehe Figur 5) vorgesehen, in welche durch Bewegen des Testmoduls 16 in Bezug auf das erste Unterstützungsglied 24 korrespondierende Bolzen 56 und 58 (siehe Figur 3) einführbar sind. Die Bolzen 56 und 58 sind an der Rückwand 36 angeordnet und erstrecken sich im Wesentlichen in Richtung der Vorderwand 34. Mit anderen Worten, die Bolzen 56 und 58 sind im Wesentlichen senkrecht an der Rückwand 36 ausgebildet. Mittels der Bolzen 56 und 58 und Öffnungen 52 und 54 ist es möglich, dass Testmodul 16 in dem Aufnahmeraum 26 physisch zu verriegeln, indem das Testmodul 16 auf die Bolzen 56 und 58 geschoben wird bzw. schiebbar ist.

Zum Bewegen des Testmoduls 16 in dem Grundmodul 14 kann ein Aufnahmeglied 60 (siehe Figur 3) vorgesehen sein, welches in Bezug auf das erste Unterstützungsglied 24 beweglich ausgebildet ist. Ferner ist vorgesehen, dass das Testmodul 16 in das Aufnahmeglied 60 eingesetzt wird bzw. auf das Aufnahmeglied 60 gesetzt wird, wobei das Testmodul 16 an dem Aufnahmeglied 60 fixiert ist. Zum Fixieren des Testmoduls 16 an dem Aufnahmeglied 60 kann das Aufnahmeglied 60 beispielsweise Vorsprünge 61 aufweisen, welche in entsprechende Ausbuchtungen 63 des Testmoduls eingreifen, wenn das Testmodul 16 an dem Aufnahmeglied 60 angeordnet ist. Somit wird eine horizontale Bewegung des Testmoduls 16 in Bezug auf das Aufnahmeglied 60 verhindert.

Insbesondere ist das Aufnahmeglied 60 an dem ersten Unterstützungsglied 24 derart beweglich gelagert, dass es zwischen der Vorderwand 34 und Rückwand 36 linear führbar ist. Das Aufnahmeglied 60 weist ferner ein erstes Aufnahmeelement 62 und ein zweites Aufnahmeelement 64 auf, welche gegenüberliegend angeordnet sind, wobei das Testmodul 16 im eingesetzten Zustand zwischen dem ersten Aufnahmeelement 62 und dem zweiten Aufnahmeelement 64 angeordnet ist. Ferner weißen das erste Aufnahmeelement 62 und das zweite Aufnahmeelement 64 jeweils mindestens zwei der zuvor genannten Vorsprünge 61 auf. Ferner ist das erste Aufnahmeelement 62 der Seitenwand 30 des ersten Unterstützungsglieds 24 zugeordnet und das zweite Aufnahmeelement 64 der Seitenwand 32 des ersten Unterstützungsglieds 24 zugeordnet.

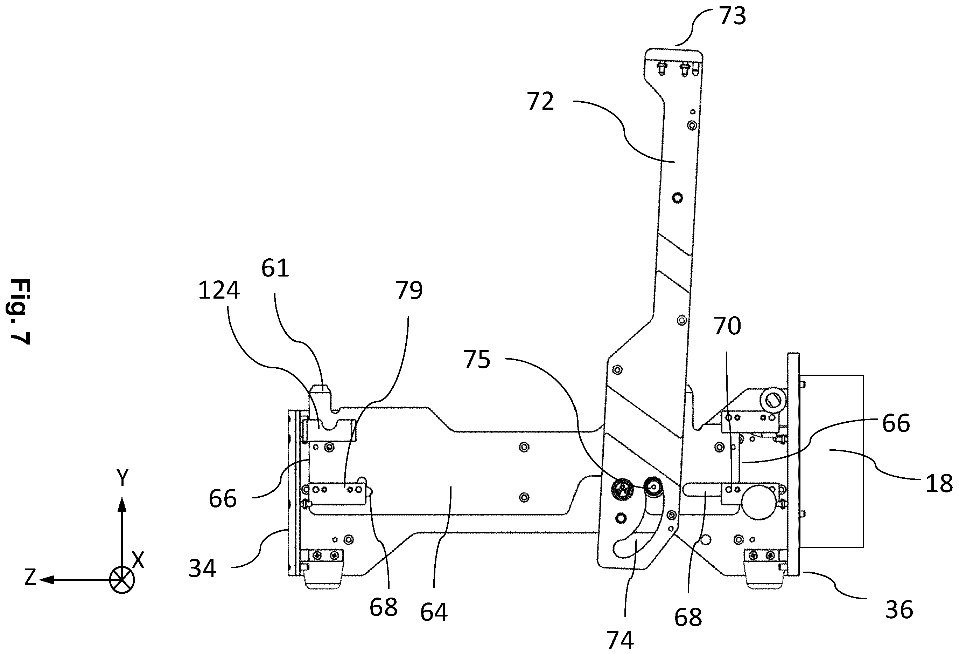

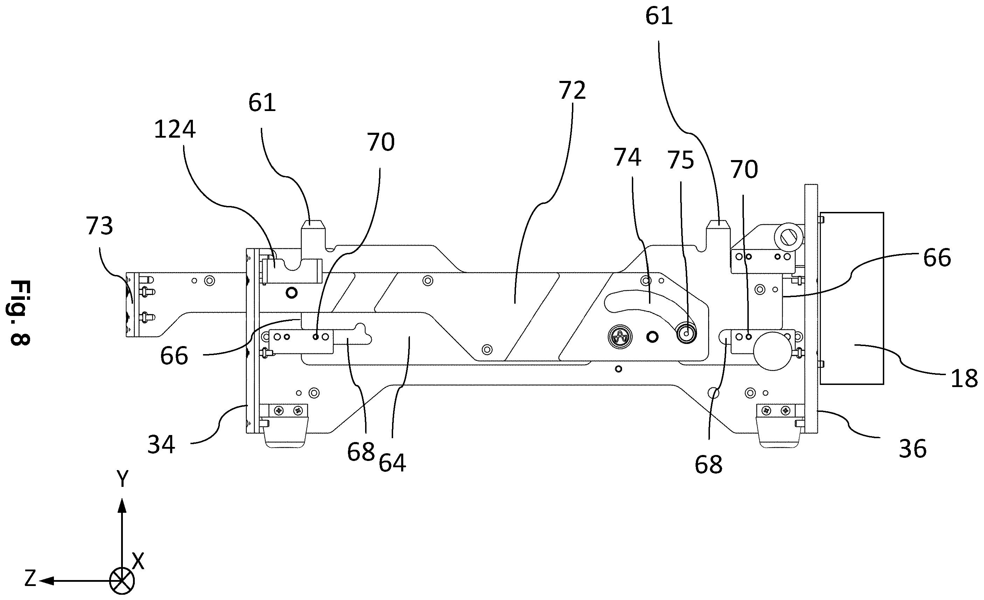

Wie in den Figuren 7 und 8 gezeigt, weisen das erste Aufnahmeelement 62 und das zweite Aufnahmeelement 64 jeweils an ihren in horizontaler Richtung liegenden Enden 66 im Wesentlichen horizontal verlaufende Aussparungen 68 auf, mittels derer das erste Aufnahmeelement 62 und das zweite Aufnahmeelement 64 auf an dem ersten Unterstützungsglied 24 angeordneten Lagerelementen 70 in horizontaler Richtung beweglich gelagert sind. Es ist anzumerken, dass in den Figuren 7 und 8 das erste Aufnahmeelement 62 verdeckt ist, da es sich um eine Seitenansicht handelt. Ferner werden in den Figuren 7 und 8 zum Zweck einer besseren Verständlichkeit nur die wichtigsten Elemente gezeigt und insbesondere das zweite Unterstützungsglied 28 weggelassen.

Wie aus den Figuren 7 und 8 weiter ersichtlich, ist es möglich, das erste Aufnahmeelement 62 und das zweite Aufnahmeelement 64 in einer Bewegungsebene hin und her zu bewegen. Die Bewegungsebene verläuft beim bestimmungsgemäßen Gebrauch des Testsystems im Wesentlichen horizontal, d.h., das erste Aufnahmeelement 62 und das zweite Aufnahmeelement 64 sind in Richtung der Vorderwand 34 und in Richtung der Rückwand 36 hin und her bewegbar. Bevorzugt sind das erste Aufnahmeelement 62 und das zweite Aufnahmeelement 64 ausschließlich in der Bewegungsebene bewegbar.

Zum Bewegen des Testmoduls 16 bzw. des Aufnahmeglieds 60 kann an dem Grundmodul 14 eine erste Bedieneinheit 72 vorgesehen sein (siehe Figur 1). Die erste Bedieneinheit 72 ist in Bezug auf das erste Unterstützungsglied 24 verschwenkbar und kann von einer Verriegelungsposition (siehe Figur 8), in der das Testmodul 16 in dem Grundmodul 14 verriegelt ist, in eine Entriegelungsposition (siehe Figur 7), in der das Testmodul 16 in dem Grundmodul 14 entriegelt ist, verschwenkt werden. Die erste Bedieneinheit 72 kann insbesondere verschwenkbar an dem ersten Unterstützungsglied 24 angeordnet sein. Die erste Bedieneinheit 72 kann ferner einen Griff 73 aufweisen, mittels dessen die erste Bedieneinheit 72 durch einen Nutzer gegenüber dem ersten Unterstützungsglied 24 verschwenkt werden kann.

Ferner kann die erste Bedieneinheit 72 im geschlossenen Zustand des Grundmoduls 14 nur die Verriegelungsposition einnehmen. Dagegen kann im geöffneten Zustand des Grundmoduls 14, die erste Bedieneinheit 72 sowohl die Verriegelungsposition als auch die Entriegelungsposition einnehmen. Ein Entriegeln des Testmoduls 16 ist somit nur im geöffneten Zustand des Grundmoduls 14 möglich. Zum Bewegen des Aufnahmeglieds 60 weist die erste Bedieneinheit 72 für das erste Aufnahmeelement 62 und das zweite Aufnahmeelement 64 jeweils eine erste Kulissenführung 74 auf. Die erste Bedieneinheit 72 kann im Wesentlichen U-förmig ausgebildet sein und zwei gegenüberliegende Schenkel 75 aufweisen, die durch den Griff 73 verbunden sind. Ferner ist in jedem Schenkel 75 eine erste Kulissenführung 74 ausgebildet und die Schenkel 75 sind jeweils derart an dem ersten Unterstützungsglied 14 angeordnet, dass die erste Bedieneinheit 72 in Bezug auf das erste Unterstützungsglied 24 verschwenkbar ist. Ferner weisen jeweils das erste Aufnahmeelement 62 und das zweite Aufnahmeelement 64 ein erstes Nockenelement 71 auf, welche jeweils in der entsprechenden Kulissenführungen 74 führbar gelagert sind. Ferner ist vorgesehen, dass die erste Kulissenführung 74 einen geschwungenen Verlauf aufweist, sodass durch Bewegen der ersten Bedieneinheit 72 von der Verriegelungsposition in die Entriegelungsposition, das in dem Aufnahmeglied 60 angeordnete Testmodul 16 in Richtung der Vorderwand 34 geführt wird. Beim Bewegen der ersten Bedieneinheit 72 von der Entriegelungsposition in die Verriegelungsposition wird das Testmodul 16 in die entgegengesetzte Richtung, in Richtung der Rückwand 36, bewegt. Ferner ist vorgesehen, dass in der Entriegelungsposition die Bolzen 56 und 58 nicht oder nur minimal in die Öffnungen 52 und 54 eingreifen. In der Verriegelungsposition dagegen wird das Testmodul 16 auf die Bolzen 56 und 58 geschoben, sodass die Bolzen 56 und 58 in die Öffnungen 52 bzw. 54 eingreifen.

Wie oben erwähnt ist der zweite Kontaktierungsabschnitt 40 des Testmoduls 16 dazu ausgebildet, dass Schnittstellenmodul 18 elektrisch zu kontaktieren. Dazu kann das Schnittstellenmodul 18 einen in Figur 1 gezeigten entsprechenden grundmodulseitigen Kontaktierungsabschnitt 76 aufweisen, der mit dem zweiten Kontaktierungsabschnitt 40 des Testmoduls 16 elektrisch verbindbar ist. Es kann vorgesehen sein, dass das Schnittstellenmodul 18 derart an dem Grundmodul 14 angeordnet ist, dass im verriegelten Zustand des Testmoduls 16 in dem Grundmodul 14 der grundmodulseitige Kontaktierungsabschnitt 76 dem zweiten Kontaktierungsabschnitts 40 gegenüberliegend angeordnet ist. Beispielsweise kann das Schnittstellenmodul 18 an der Außenseite der Rückwand 36 angeordnet sein (siehe Figur 8). Des Weiteren ist vorgesehen, dass das Schnittstellenmodul 18 lösbar mit dem Grundmodul 14 verbunden ist, sodass das Schnittstellenmodul 18 einfach ausgetauscht werden kann.

Der zweite Kontaktierungsabschnitt 40 und der grundmodulseitige Kontaktierungsabschnitt 76 können als Pylonstecker ausgebildet sein, um sich gegenseitig elektrisch zu kontaktieren. In der Verriegelungsposition des Testmoduls 16 ist vorgesehen, dass der zweite Kontaktierungsabschnitt 40 den grundmodulseitigen Kontaktierungsabschnitt 76 elektrisch kontaktiert. Durch Bewegen der Bedieneinheit ersten 72 in die Entriegelungsposition erfährt das Testmodul 16 eine Relativbewegung in Bezug auf das Schnittstellenmodul 18 derart, dass das Testmodul 16 von dem Schnittstellenmodul 18 fortbewegt wird, wodurch das Testmodul 16 von dem Schnittstellenmodul 18 elektrisch und/oder physisch getrennt wird. Insbesondere wird die elektrische Verbindung des zweiten Kontaktierungsabschnitts 40 und des grundmodulseitigen Kontaktierungsabschnitts 76 getrennt. Umgekehrt wird beim Bewegen der ersten Bedieneinheit 72 von der Entriegelungsposition in die Verriegelungsposition der zweite Kontaktierungsabschnitt 40 mit dem grundmodulseitigen Kontaktierungsabschnitt 76 elektrisch verbunden.

Ferner kann vorgesehen sein, dass der erste Kontaktierungsabschnitt 20 mit dem zweiten Kontaktierungsabschnitt 40 zumindest teilweise, bevorzugt vollständig, durch Wire-Wrapping miteinander elektrisch verbunden ist. Insbesondere sind die in dem Testmodul 16 innenliegenden Kontaktpins des ersten Kontaktierungsabschnitts 20 und des zweiten Kontaktierungsabschnitts 40 mittels Wire-Wrapping miteinander elektrisch verbunden. Ebenso kann vorgesehen sein, dass die in dem Schnittstellenmodul 18 innenliegenden Kontaktpins des grundmodulseitigen Kontaktierungsabschnitts 76 mittels Wire-Wrapping mit einem testvorrichtungsseitigen Kontaktierungsabschnitt (nicht gezeigt) des Schnittstellenmoduls 18 elektrisch verbunden sind. Mittels des testvorrichtungsseitigen Kontaktierungsabschnitts ist es ferner möglich, die Testverrichtung 12 elektrisch mit dem Schnittstellenmodul 18 zu verbinden.

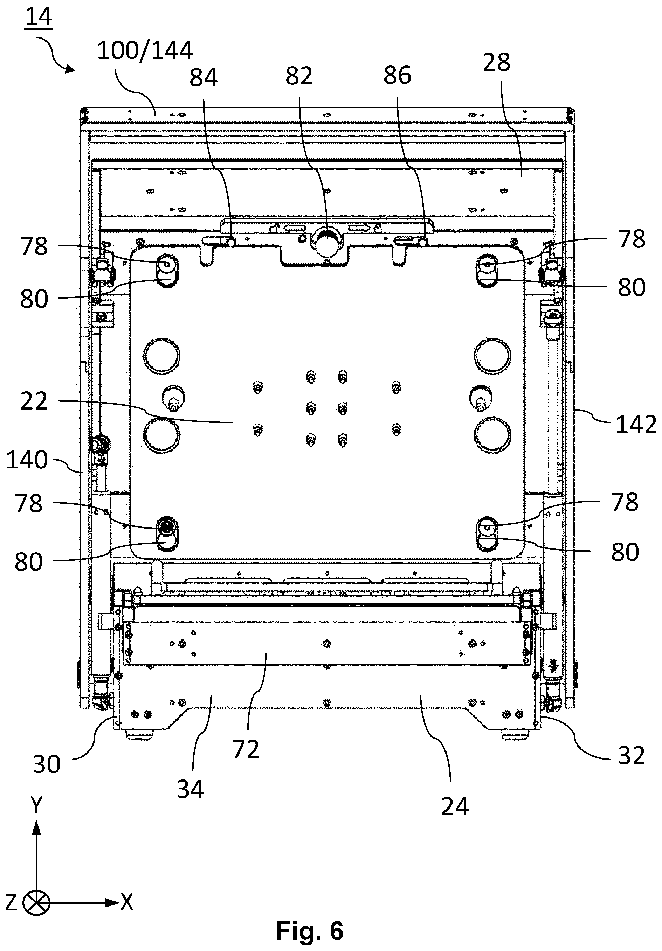

Wie oben erwähnt weist das Grundmodul 14 ein mit dem Grundmodul 14 kuppelbares Fixierungsmodul 22 auf. Das Kuppeln des Fixierungsmoduls 22 mit dem Grundmodul 14 wird im Folgenden unter Bezugnahme auf die Figur 6 näher erläutert. Wie in Figur 6 dargestellt, ist das Fixierungsmodul 22 im Wesentlichen flach und plattenförmig ausgebildet. Ferner ist das Fixierungsmodul 22 derart an dem zweiten Unterstützungsglied 28 anordenbar, dass im geschlossenen Zustand des Grundmoduls 14, das Fixierungsmodul 22 dem ersten Kontaktierungsabschnitt 20 gegenüberliegend und bevorzugt parallel zu dem ersten Kontaktierungsabschnitt 20 angeordnet ist. Des Weiteren weist das zweite Unterstützungsglied 28 mehrere Aufnahmepunkte 78 auf, mittels derer das Fixierungsmodul 22 über entsprechende Aufnahmeöffnungen 80, welche an dem Fixierungsmodul 22 ausgebildet sind, an dem zweiten Unterstützungsglied 28 schwimmend lagerbar ist. Die Aufnahmeöffnungen 80 können beispielsweise als Schlüssellochöffnungen ausgebildet sein, wobei die Aufnahmepunkte 78 durch die entsprechenden Aufnahmeöffnungen 80 hindurchführbar sind.

Des Weiteren weist das zweite Unterstützungsglied 28 eine Verriegelung 82 auf, mittels derer die Verriegelungselemente 84 und 86 in eine Verriegelungsposition und in eine Entriegelungsposition bewegbar sind. In der Verriegelungsposition fixieren die Verriegelungselemente 84 und 86 das Fixierungsmodul 22 derart an dem zweiten Unterstützungsglied 28, dass das Fixierungsmodul 22 von den Aufnahmepunkten 78 nicht gelöst werden kann. In der Entriegelungsposition der Verriegelungselemente 84 und 86 ist das Fixierungsmodul 22 in Bezug auf das zweite Unterstützungsglied 28 bewegbar, sodass das Fixierungsmodul 22 von den Aufnahmepunkten 78 gelöst werden kann. Somit kann auf einfache Weise ein Wechsel des Fixierungsmoduls 22 vorgenommen werden.

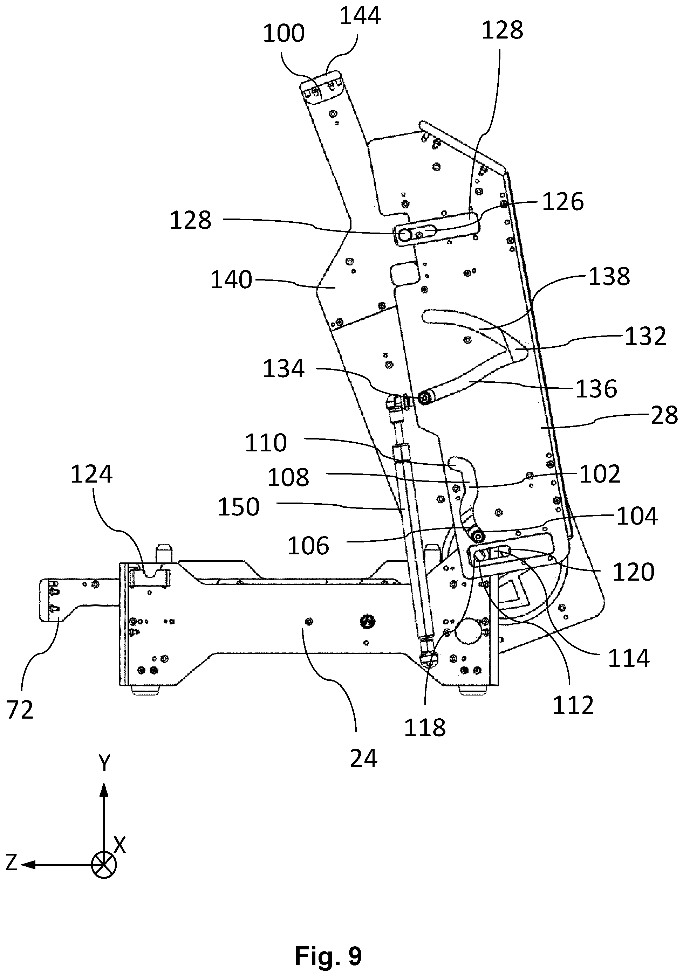

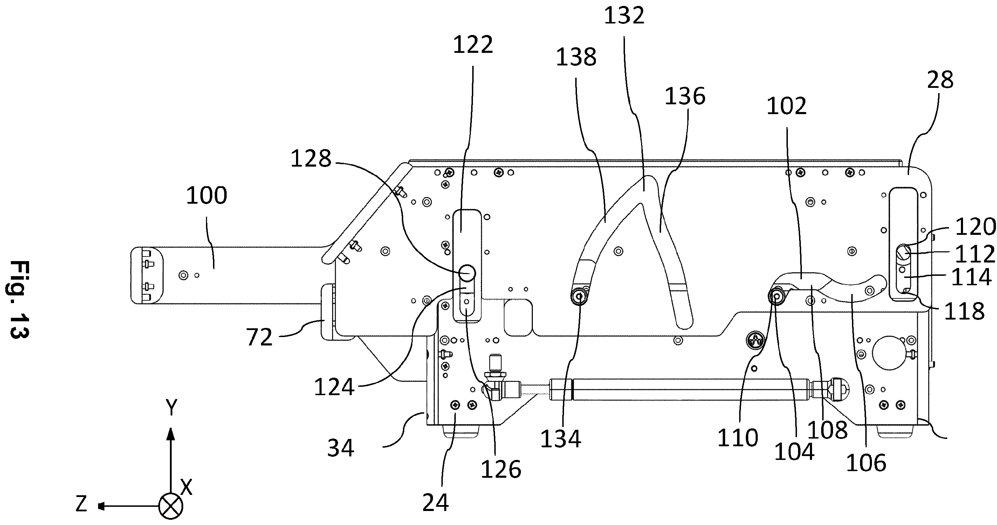

Ferner weist das Grundmodul 14 wie in Figur 1 dargestellt, eine relativ zu dem ersten Unterstützungsglied 24 verschwenkbar gelagerte zweite Bedieneinheit 100 auf. Durch Bewegen bzw. Verschwenken der zweiten Bedieneinheit 100 in Bezug auf das erste Unterstützungsglied kann das Grundmodul 14 geöffnet und geschlossen werden. Insbesondere ist die zweite Bedieneinheit 100 an dem ersten Unterstützungsglied 24 verschwenkbar gelagert angeordnet, sodass die zweite Bedieneinheit 100 in Bezug auf das erste Unterstützungsglied 24 bewegbar ist. Durch Verschwenken der zweiten Bedieneinheit 100 gegenüber dem ersten Unterstützungsglied 24 ist das zweite Unterstützungsglied 28 in eine Öffnungsposition bewegbar (siehe Figur 9), in der die zu testende elektrische Baugruppe durch das Fixierungsmodul 22 freigegeben ist und somit austauschbar ist. Ferner kann durch Verschwenken der zweiten Bedieneinheit 100 gegenüber dem ersten Unterstützungsglied 24 das zweite Unterstützungsglied 28 in eine Verschlussposition (siehe Figur 2 und 13) bewegt werden, in der die zu testende elektrische Baugruppe durch das Fixierungsmodul 22 an dem Testmodul 16 fixiert ist. Ferner ist das Grundmodul 14 in der Verschlussposition geschlossen und in der Öffnungsposition geöffnet.

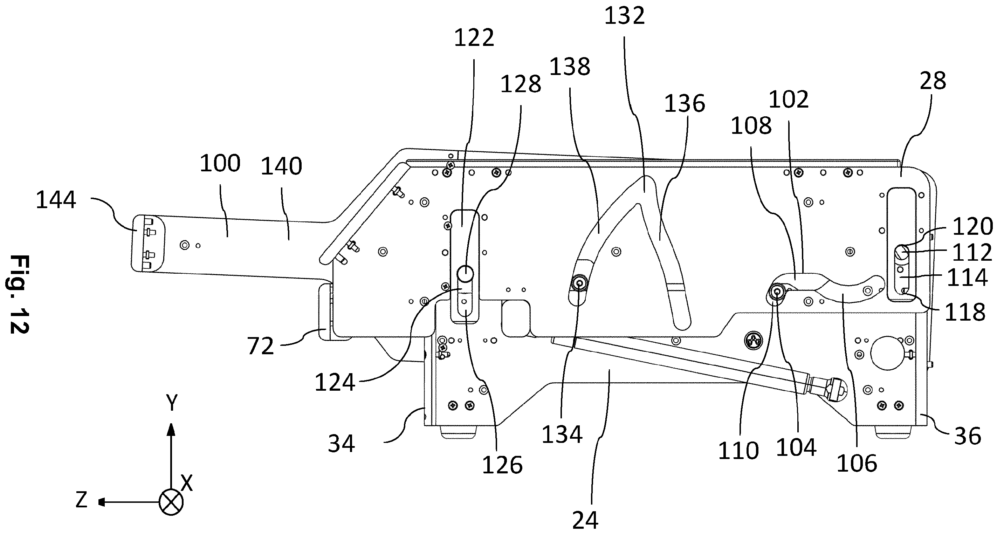

Bezugnehmend auf die Figuren 1 und 9-13 wird im Folgenden das Öffnen und Schließen des Grundmoduls 14 erläutert. Das zweite Unterstützungsglied 28 ist an dem ersten Unterstützungsglied 24 verschwenkbar gelagert, um in Bezug auf das erste Unterstützungsglied 24 bewegbar zu sein. Des Weiteren weist das zweite Unterstützungsglied 28 eine zweite Kulissenführung 102 auf, in der ein an der zweiten Bedieneinheit 100 angeordnetes zweites Nockenelement 104 entlang führbar ist. Die zweite Kulissenführung 102 weist ferner einen geschwungenen Abschnitt 106, einen sich an den geschwungenen Abschnitt 106 anschließenden ersten linearen Abschnitt 108 und einen sich an den ersten linearen Abschnitt 108 anschließenden zweiten linearen Abschnitt 110 auf. Um das zweite Unterstützungsglied 28 von der Öffnungsposition in die Verschlussposition zu bewegen, wird durch Verschwenken der zweiten Bedieneinheit 100 das zweite Nockenelement 104 den geschwungenen Abschnitt 106, den ersten linearen Abschnitt 108 und den zweiten linearen Abschnitt 110 entlanggeführt (in dieser Reihenfolge). Insbesondere wird das zweite Nockenelement 104 vollständig entlang der zweiten Kulissenführung 102 entlanggeführt.

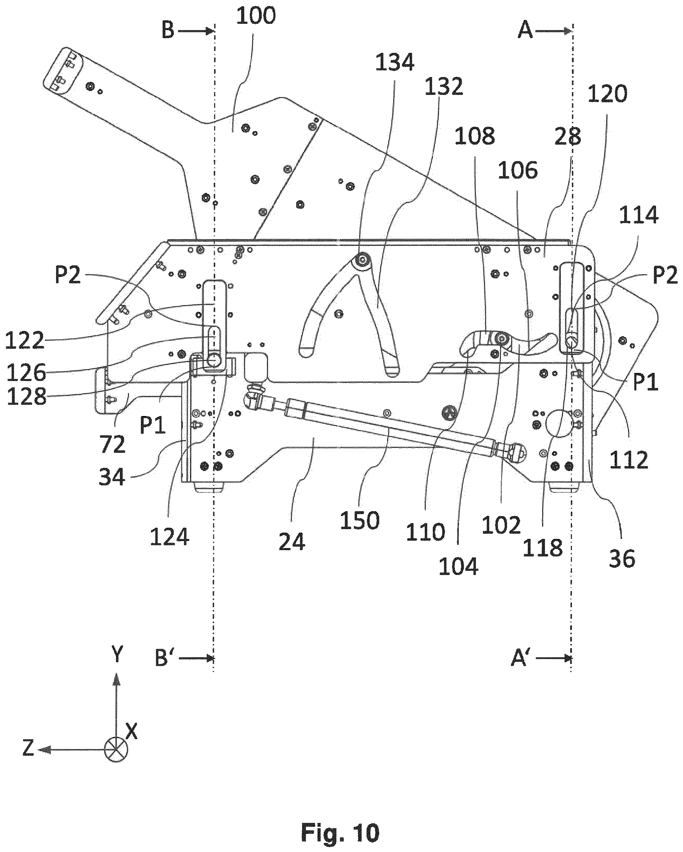

Wie aus den Figuren 9 und 10 ersichtlich wird durch Entlangführen des zweiten Nockenelements 104 in dem geschwungenen Abschnitt 106 der zweiten Kulissenführung 102, das zweite Unterstützungsglied 28 in Bezug auf das erste Unterstützungsglied 24 verschwenkt, sodass beim Übergang des zweiten Nockenelements von dem geschwungenen Abschnitts 106 in den ersten linearen Abschnitt 108, das Testmodul 16 und das Fixierungsmodul 22 im Wesentlichen gegenüberliegend angeordnet sind. Das Entlangführen des zweiten Nockenelements 104 an dem geschwungenen Abschnitt 106 bzw. das Verschwenken des zweiten Unterstützungsglieds 28 in Bezug auf das erste Unterstützungsglied 24 wird als erste Bewegungsphase bezeichnet. Die erste Bewegungsphase endet, wenn das zweite Nockenelement 104 von dem geschwungenen Abschnitt 106 in den ersten linearen Abschnitt 108 übergeht.

Durch fortsetzen des Verschwenkens der zweiten Bedieneinheit 100 bzw. herunterdrücken der zweiten Bedieneinheit 100 in Richtung des ersten Unterstützungsglieds 24, wird das zweite Nockenelement 104 den ersten linearen Abschnitt 108 und bevorzugt den zweiten linearen Abschnitt 110 entlanggeführt, wodurch ein Absenken des zweiten Unterstützungsglieds 28 in Richtung des ersten Unterstützungsglieds 24 erfolgt. Insbesondere erfolgt das Absenken des zweiten Unterstützungsglieds 28 in Richtung des ersten Unterstützungsglieds 24 durch eine linear geführte Bewegung des zweiten Unterstützungsglieds 28. Das Entlangführen des zweiten Nockenelements 104 an dem ersten linearen Abschnitt 108 und an dem zweiten linearen Abschnitt 110 wird als zweite Bewegungsphase bezeichnet, welche durch die linear geführte Bewegung des zweiten Unterstützungsglieds 28 in Richtung des ersten Unterstützungsglieds 24 gekennzeichnet ist. Unter einer linear geführten Bewegung des zweiten Unterstützungsglieds 28 in Richtung des ersten Unterstützungsglieds 24 wird eine Bewegung verstanden, bei der der Normalenvektor des Fixierungsmoduls 22 im Wesentlichen parallel zu dem Normalenvektor des Testmoduls 16 verläuft. Der Normalenvektor des Fixierungsmoduls 22 ist dabei auf die Seite des Fixierungsmoduls 22 bezogen, welche im geschlossenen Zustand des Grundmoduls 14 dem Testmodul 16 zugewandt ist. Des Weiteren ist der Normalenvektor des Testmoduls 16 dabei auf die Seite des Testmoduls 16 bezogen, welche im geschlossenen Zustand des Grundmoduls 14 dem Fixierungsmodul 22 zugewandt ist.

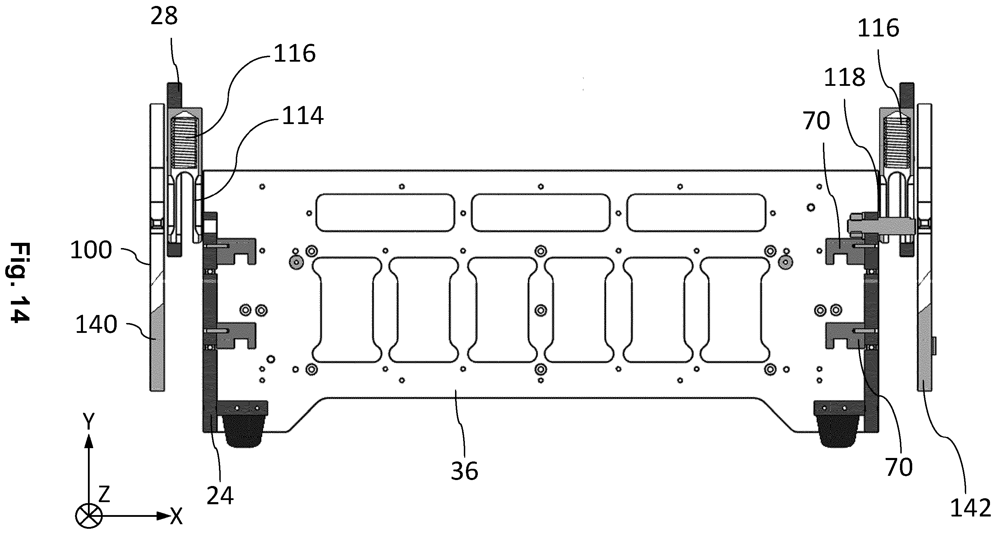

Zur Unterstützung der linear geführten Bewegung des zweiten Unterstützungsglieds 28 in Richtung des ersten Unterstützungsglieds 24, kann das zweite Unterstützungsglied 28 an dem ersten Unterstützungsglied 24 federnd gelagert sein. Insbesondere kann das zweite Unterstützungsglied 28 an einem Aufnahmepunkt 112 des ersten Unterstützungsglieds 24 verschwenkbar und gefedert angeordnet ist. Dazu kann das zweite Unterstützungsglied 28 mittels eines ersten Langlochs 114 an dem Aufnahmepunkt 112 des ersten Unterstützungsglieds 24 verschwenkbar in Bezug auf das erste Unterstützungsglied 24 gelagert sein. Dabei ist in dem ersten Langloch 114 ein Federelement 116 angeordnet, welches derart auf den Aufnahmepunkt 116 wirkt, dass der Aufnahmepunkt 116 an einem ersten Ende 118 des ersten Langlochs 114 liegt. Figur 14 zeigt einen Querschnitt durch das Grundmodul 14 entlang der in Figur 10 gezeigten Schnittebene A-A'. Dabei zeigt Figur 14 das erste Langloch 114 in dem das Federelement 116 angeordnet ist, welches auf den Aufnahmepunkt 112 wirkt.

Während der ersten Bewegungsphase wird der Aufnahmepunkt 112 durch das Federelement 116 des ersten Langlochs an dem ersten Ende 118 des Langlochs 114 gehalten. Ferner verlagert sich mit dem Einsetzen der zweiten Bewegungsphase der Aufnahmepunkt 112 in Richtung des zweiten Endes 120 des Langlochs 114, sodass zum Ende der zweiten Bewegungsphase der Aufnahmepunkt 112 am zweiten Ende 120 des Langlochs 118 liegt. Das zweite Unterstützungsglied 28 kann somit auf vorteilhafte Weise einfach an dem Aufnahmepunkt 112 des ersten Unterstützungsglieds 24 federnd gelagert und verschwenkbar ausgebildet sein.

Ferner kann das zweite Unterstützungsglied 28 einen federgelagerten Anschlag 122 aufweisen, der beim Bewegen des zweiten Unterstützungsglieds 28 von der Öffnungsposition in die Verschlussposition auf ein an dem ersten Unterstützungsglied 24 angeordneten Auflagerpunkt 124 geführt wird. Ferner kontaktiert der federgelagerte Anschlag 122 erst mit Beginn der zweiten Bewegungsphase den Auflagerpunkt 124 des ersten Unterstützungsglieds 24. Der federgelagerte Anschlag 122 kann ferner eine erste Anschlagposition P1, siehe Figur 10, und eine zweite Anschlagposition P2, siehe Figur 13, aufweisen, wobei während der ersten Bewegungsphase der federgelagerte Anschlag 122 die erste Anschlagposition P1 aufweist und während der zweiten Bewegungsphase in die zweite Anschlagposition P2 bewegt wird. Mit anderen Worten, zu Beginn der zweiten Bewegungsphase ist der federgelagerte Anschlag 122 in der ersten Anschlagposition P1 und am Ende der zweiten Bewegungsphase in der Anschlagposition P2. Ferner entspricht das Bewegen des federgelagerten Anschlags 122 von der ersten Anschlagposition P1 in die zweite Anschlagposition P2 einem Einfedern des federgelagerten Anschlags 122.

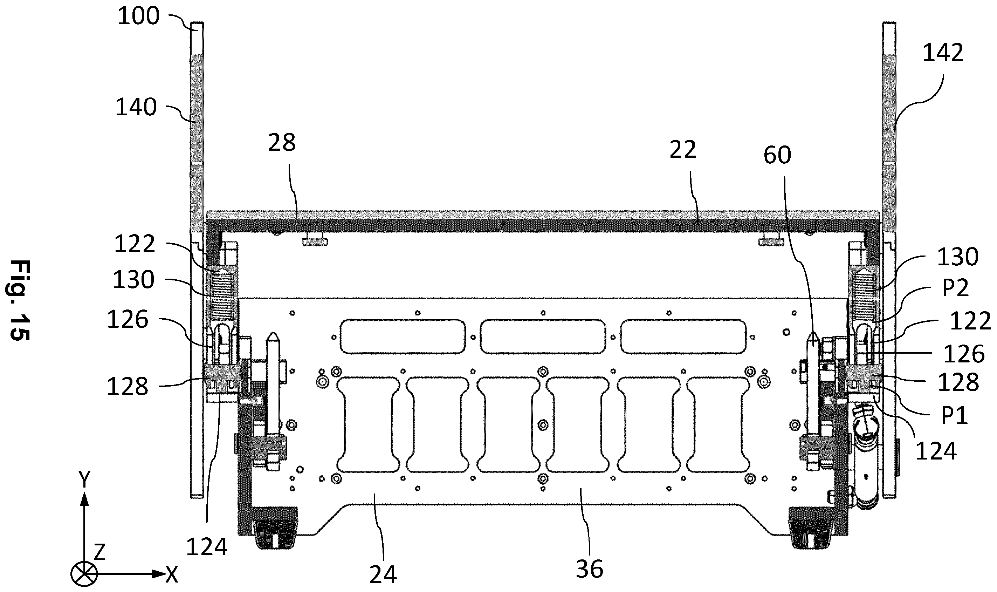

Ferner kann der federgelagerte Anschlag 122 ein zweites Langloch 126 aufweisen, in welchem ein Anschlagelement 128 federgelagert ist und welches zwischen den beiden Enden des zweiten Langlochs 126 bzw. der ersten Anschlagposition P1 und zweiten Anschlagposition P2 bewegbar ist. Figur 15 zeigt einen Querschnitt durch das Grundmodul 14 entlang der in Figur 10 gezeigten Schnittebene B-B'. Dabei zeigt Figur 15 das zweite Langloch 126 in dem ein Federelement 130 angeordnet ist, welches auf das Anschlagelement 128 wirkt. Zu Beginn der zweiten Bewegungsphase ist das Anschlagelement 128 in der ersten Anschlagposition P1 und am Ende der zweiten Bewegungsphase in der Anschlagposition P2.

Während der zweiten Bewegungsphase werden der federgelagerte Anschlag 122 und die Federlagerung des zweiten Unterstützungsglieds 28 an dem Aufnahmepunkt 112 des ersten Unterstützungsglieds 24 gleichmäßig betätigt, wodurch ein gleichmäßiges Absenken, insbesondere lineares Absenken, des zweiten Unterstützungsglieds 28 auf das erste Unterstützungsglied 24 erfolgt. Folglich wird auch das Fixierungsmodul 22 linear auf das Testmodul 16 abgesenkt.

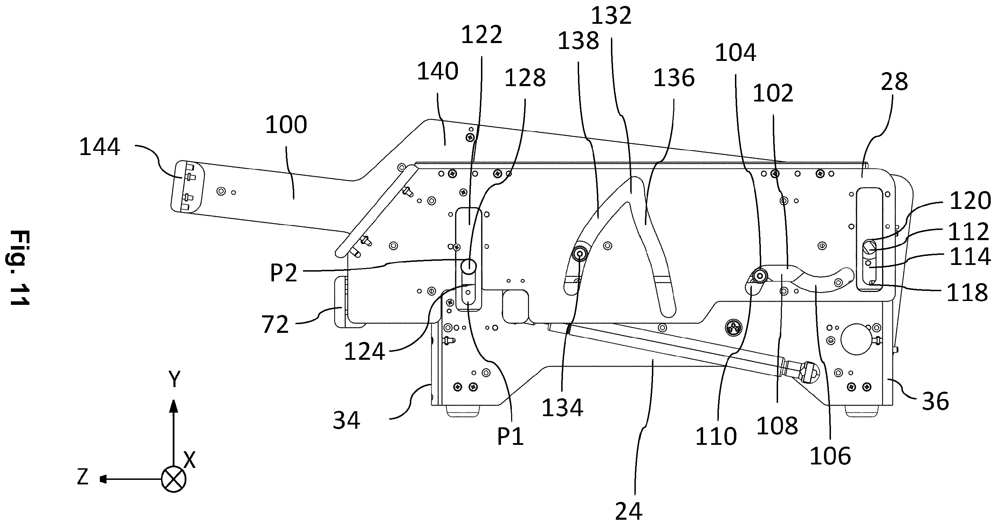

Vorzugsweise ist der zweite lineare Abschnitt 110 in Bezug auf den ersten linearen Abschnitt 108 abgewinkelt. Insbesondere verläuft der erste lineare Abschnitt 108 zu Beginn der zweiten Bewegungsphase im Wesentlichen parallel zu einer von der Oberseite 44 des Testmoduls 16 aufgespannten Ebene. Ferner weist der zweite lineare Abschnitt 110 zu Beginn der zweiten Bewegungsphase ausgehend von dem ersten linearen Abschnitt 108 in Richtung des ersten Unterstützungsglieds 24. Beim Übergang des zweiten Nockenelements 104 vom ersten linearen Abschnitt 108 in den zweiten linearen Abschnitt 110 wird das zweite Unterstützungsglied 28 durch die Federlagerung des zweiten Unterstützungsglieds 28 an dem ersten Unterstützungsglied 24 von dem ersten Unterstützungsglied 24 weggedrückt. Anschließend wird durch Entlangfahren des zweiten Nockenelements 104 in dem zweiten linearen Abschnitt 110 das zweite Unterstützungsglied 28 wieder in Richtung des ersten Unterstützungsglieds 24 bewegt. Durch den Übergang des zweiten Nockenelements 104 in den zweiten linearen Abschnitt 110 arretiert das zweite Unterstützungsglied 28 somit die zweite Bedieneinheit 100, sodass die zweite Bedieneinheit 100 nicht selbstständig verschwenkt werden kann. Insbesondere wird die zweite Bedieneinheit 100 durch das zweite Unterstützungsglied 28 arretiert, wenn das zweite Nockenelement 104 in dem zweiten linearen Abschnitt 110 unter das Niveau des ersten linearen Abschnitts 108 fällt (siehe Figuren 11-13).

Das zweite Unterstützungsglied 28 kann ferner eine dritte Kulissenführung 132 aufweisen, in der ein drittes Nockenelement 134 der zweiten Bedieneinheit 100 führbar gelagert ist. Die dritte Kulissenführung 132 kann insbesondere dazu ausgebildet sein, während einem Verschwenken der zweiten Bedieneinheit 100, das zweite Unterstützungsglied 28 in Bezug auf das erste Unterstützungsglied 24 zu stabilisieren. Die dritte Kulissenführung 132 weist einen ersten Abschnitt 136 auf, an den sich ein zweiter Abschnitt 138 anschließt, wobei der zweite Abschnitt 138 gegenüber dem ersten Abschnitt 136 abgewinkelt ist. Ferner wird das dritte Nockenelements 134 während der ersten Bewegungsphase an dem ersten Abschnitt 136 entlanggeführt und während der zweiten Bewegungsphase entlang des zweiten Abschnitts 138 entlanggeführt.

Die zweite Bedieneinheit 100 kann U-förmig ausgebildet sein und zwei gegenüberliegende Seitenabschnitte 140 und 142 aufweisen, welche an einem Ende durch einen Griff 144 miteinander verbunden sind. Im geschlossenen Zustand des Grundmoduls 14 ist der Griff 144 der zweiten Bedieneinheit 100 an der Vorderseite des Grundmoduls 14 angeordnet. Die Seitenabschnitte 140 und 142 sind jeweils seitlich außenliegend an dem Grundmodul 14 angeordnet und können jeweils ein zweites Nockenelement 104 und ein drittes Nockenelement 134 aufweisen. Ferner ist die zweite Bedieneinheit 100 an den offenen Enden der Seitenabschnitte 140 und 142 schwenkbar mit dem ersten Unterstützungsglied 24 verbunden. Insbesondere kann der Seitenabschnitt 140 an der Seitenwand 30 des ersten Unterstützungsglieds 24 verschwenkbar angeordnet sein und der Seitenabschnitt 142 an der Seitenwand 32 des ersten Unterstützungsglieds 24 verschwenkbar angeordnet sein.

Ferner weist das zweite Unterstützungsglied 28 zwei gegenüberliegende Seitenelemente 146 und 148 auf, welche jeweils eine zweite Kulissenführung 102 und ein dritte Kulissenführung 132 aufweisen. Ferner kann das Seitenelement 146 des zweiten Unterstützungsglieds 28 an der Seitenwand 30 des ersten Unterstützungsglieds 24 verschwenkbar angeordnet, wobei die Seitenwand 30 hierzu den Aufnahmepunkt 112 vorsieht. Ebenso ist das Seitenelement 148 des zweiten Unterstützungsglieds 28 an der Seitenwand 32 des ersten Unterstützungsglieds 24 verschwenkbar angeordnet, wobei hierzu die Seitenwand 32 ebenfalls einen Aufnahmepunkt 112 vorsieht. Ferner weist jedes Seitenelement 146 und 148 des zweiten Unterstützungsglieds 28 ein erstes Langloch 114 und einen federgelagerten Anschlag 122 auf. In einer Draufsicht auf das geschlossenen Grundmoduls 14 weist das zweite Unterstützungsglied 28 eine im Wesentlichen rechteckige Form auf, wobei durch die federgelagerten Anschläge 122 und Langlöcher 114 das zweite Unterstützungsglied 28 an vier Punkten an dem ersten Unterstützungsglied 24 federgelagert ist.

Des Weiteren ist ein Federunterstützungselement 150 vorgesehen, welches das zweite Unterstützungsglied 28 mit dem ersten Unterstützungsglied 24 verbindet. Das Federunterstützungselement 150 kann beispielsweise ein Gasdruckfederelement sein.

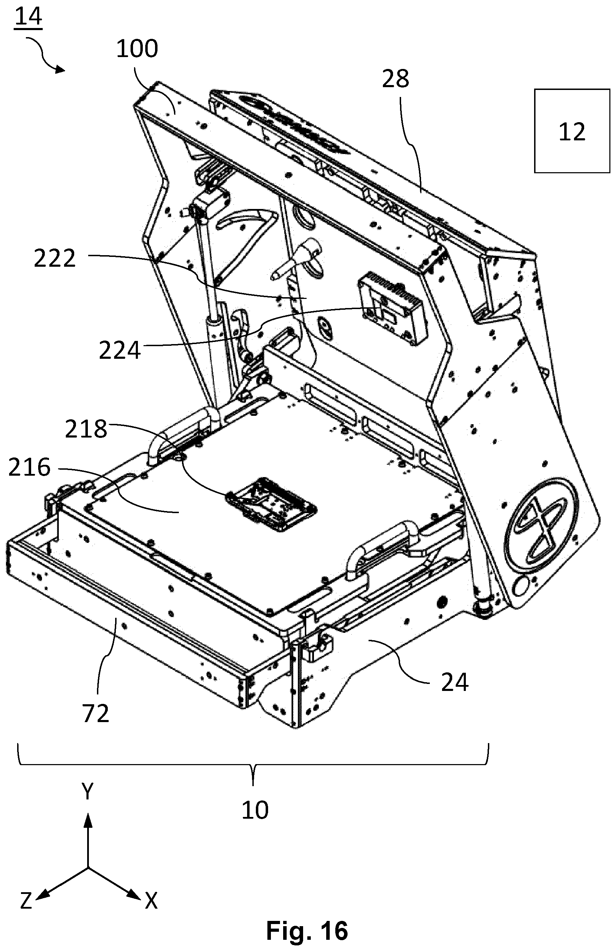

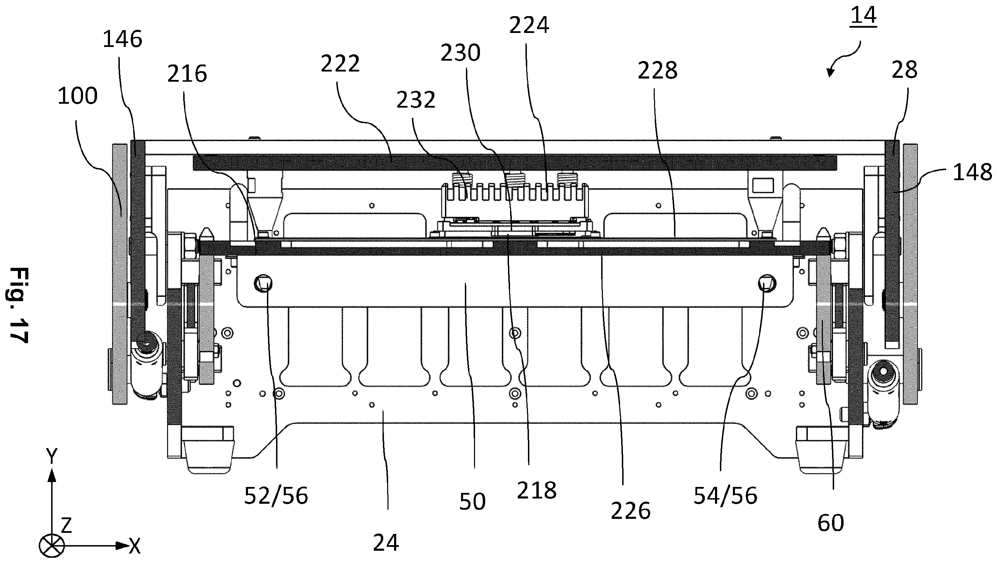

Figuren 16 und 17 zeigen eine weitere Ausführungsform des modularen Testsystems 10. Im Unterschied zu der zuvor beschriebenen Ausführungsform des modularen Testsystems 10, weist das Testmodul 16 einen Sockel 218 auf, an dem die zu testende elektrische Baugruppe angeordnet werden kann. Ferner weist das Fixierungsmodul 222 eine Sockelabdeckung 224 auf, die im geschlossenen Zustand des Grundmoduls 14 die zu testende elektrische Baugruppe an dem Sockel 218 fixiert.

Insbesondere ist der Sockel 218 an einer Seite des Testmoduls 216 angeordnet, welche im geschlossenen Zustand des Grundmoduls 14 dem Fixierungsmodul 222 zugewandt ist. Ebenso ist die Sockelabdeckung 224 an einer Seite des Fixierungsmoduls 222 angeordnet, welche im geschlossenen Zustand des Grundmoduls 14 dem Testmodul 216 zugewandt ist.

Im geöffneten Zustand des Grundmoduls 14, d. h., wenn das zweite Unterstützungsglied 28 gegenüber dem ersten Unterstützungsglied 24 nach oben verschwenkt ist bzw. das zweite Unterstützungsglied 28 sich am Anfang der ersten Bewegungsphase befindet, ist die zu testende elektrische Baugruppe durch die Sockelabdeckung 224 freigegeben, um die zu testende elektrische Baugruppe auszutauschen.

Wie in Figur 17 gezeigt, wird das Testmodul 216 auf das Aufnahmeglied 60 aufgesetzt, sodass, wie oben für das Testmodul 16, beschrieben das Testmodul 216 durch Verschwenken der ersten Bedieneinheit 72 bewegbar ist und mit dem ersten Unterstützungsglied 24 verriegelt und entriegelt werden kann. Des Weiteren besteht das Testmodul 216 aus einer stabilen Tragschicht 226, welche auf das Aufnahmeglied 60 aufgesetzt wird. Auf einer dem Fixierungsmodul 222 zugewandten Seite der Tragschicht 226 ist eine Substratschicht 228, beispielsweise eine Leiterplatte, angeordnet mit der der Sockel 218 verbunden ist.

Ferner weist der Sockel 218 und/oder die Sockelabdeckung 224 elektrische Kontaktierungsmittel auf, welche dazu ausgebildet sind, die zu testende elektrische Baugruppe elektrisch zu kontaktieren. Ferner können die elektrischen Kontaktierungsmittel mit der Testvorrichtung 12 verbunden werden, sodass die zu testende elektrische Baugruppe einem Testverfahren bzw. Prüfverfahren unterzogen werden kann. Bevorzugt können die elektrischen Kontaktierungsmittel Fine-Pitch Felder zum elektrischen Kontaktieren der zu testenden elektrischen Baugruppe aufweisen.

Ferner umschließen der Sockel 218 und die Sockelabdeckung 224 im geschlossenen Zustand des Grundmoduls 14 einen Testraum 230, in dem die zu testende elektrische Baugruppe angeordnet werden kann. Ferner kann das Testsystem 10 dazu ausgebildet sein, einen Umweltparameter in dem Testraum 230 zu regeln bzw. zu steuern. Der Umweltparameter kann beispielsweise die Temperatur, die Luftfeuchte und/oder den Luftdruck innerhalb des Testraums 30 betreffen. Vorzugsweise ist der Sockel 218 und die Sockelabdeckung 224 massiv ausgebildet, beispielsweise aus Aluminium. Des Weiteren kann der Sockel 218 und/oder die Sockelabdeckung 224 Kühlrippen 232 aufweisen, um den Wärmeabtransport zu verbessern.

Ferner können die Sockelabdeckung 224 und/oder der Sockel 218 schwimmend an dem Fixierungsmodul 222 bzw. an dem Testmodul 216 angeordnet sein. Ebenso wie das Testmodul 16, kann das Testmodul 216 an der Rückseite 50 zwei Öffnungen zweiundfünfzig und vierundfünfzig aufweisen, welche beim Verriegeln des Testmoduls 216 auf die Bolzen 56 der Rückwand 36 aufschiebbar sind.

### Bezugszeichenliste

- 10: modulares Testsystem
- 12: Testvorrichtung
- 14: Grundmodul
- 16: Testmodul
- 18: Schnittstellenmodul
- 20: erster Kontaktierungsabschnitt Testmodul
- 22: Fixierungsmodul
- 24: erstes Unterstützungsglied
- 26: Aufnahmeraum
- 28: zweites Unterstützungsglied
- 30, 32: Seitenwände des ersten Unterstützungsglieds
- 34: Vorderwand des ersten Unterstützungsglieds
- 36: Rückwand des ersten Unterstützungsglieds
- 38: Aussparungen
- 40: zweiter Kontaktierungsabschnitt Testmodul
- 42: Gehäuse des Testmoduls
- 44: Oberseite des Testmodul
- 46, 48: Griffe
- 50: Rückseite des Testmoduls
- 52, 54: Öffnungen an Rückseite
- 56: Bolzen an Rückwand
- 60: Aufnahmeglied
- 61: Vorsprung Aufnahmeglied
- 62: erstes Aufnahmeelement
- 63: Ausbuchtung Testmodul
- 64: zweites Aufnahmeelement
- 66: horizontal liegende Enden
- 68: Aussparrungen
- 70: Lagerelemente
- 71: erstes Nockenelement
- 72: erste Bedieneinheit
- 73: Griff
- 74: erste Kulissenführung
- 75: Schenkel erste Bedieneinheit
- 76: grundmodulseitigen Kontaktierungsabschnitt
- 78: Aufnahmepunkte
- 80: Aufnahmeöffnung
- 82: Verriegelung
- 84, 86: Verriegelungselemente
- 100: zweite Bedieneinheit
- 102: zweite Kulissenführung
- 104: zweites Nockenelement
- 106: geschwungener Abschnitt
- 108: erster linearer Abschnitt
- 110: zweiter linearer Abschnitt
- 112: Aufnahmepunkt
- 114: erstes Langloch
- 116: Federelement
- 118: erstes Ende des Langlochs
- 120: zweites Ende des Langlochs
- 122: federgelagerter Anschlag
- 124: Auflagerpunkt
- 126: zweites Langloch federgelagerter Anschlag
- 128: Anschlagelement
- 130: Federelement
- 132: dritte Kulissenführung
- 134: drittes Nockenelement
- 136: erster Abschnitt dritte Kulissenführung
- 138: zweiter Abschnitt dritte Kulissenführung
- 140: Seitenabschnitt zweite Bedieneinheit
- 142: Seitenabschnitt zweite Bedieneinheit
- 144: Griff zweite Bedieneinheit
- 146: Seitenelement zweites Unterstützungsglied
- 148: Seitenelement zweites Unterstützungsglied
- 150: Federunterstützungselement
- 216: Testmodul
- 218: Sockel
- 222: Fixierungsmodul
- 224: Sockelabdeckung
- 226: Tragschicht
- 228: Substratschicht
- 230: Testraum
- 232: Kühlrippen
- P1: erste Anschlagposition
- P2: zweite Anschlagposition

## Patentansprüche

1. Verschließbares Grundmodul (14) für ein modulares Testsystem (10) zum Testen elektrischer Baugruppen, aufweisend:
- ein erstes Unterstützungsglied (24), welches einen Aufnahmeraum (26) zum Aufnehmen eines Testmoduls (16) bereitstellt, wobei an dem Testmodul (16) eine zu testende elektrische Baugruppe anordenbar ist;
- ein relativ zu dem ersten Unterstützungsglied (24) verschwenkbar gelagertes zweites Unterstützungsglied (28), welches dazu ausgebildet ist, ein Fixierungsmodul (22) zum Fixieren der zu testenden elektrischen Baugruppe an dem Testmodul (16) aufzunehmen;
- eine an dem ersten Unterstützungsglied (24) verschwenkbar gelagerte Bedieneinheit (100), welche an dem zweiten Unterstützungsglied (28) führbar gelagert ist,
wobei durch Verschwenken der Bedieneinheit (100) gegenüber dem ersten Unterstützungsglied (24), das zweite Unterstützungslied (28) in eine Öffnungsposition, in der die zu testende elektrische Baugruppe durch das Fixierungsmodul (22) freigegeben ist, und in eine Verschlussposition, in der die zu testende elektrische Baugruppe durch das Fixierungsmodul (22) an dem Testmodul (16) fixiert ist, bewegbar ist, und
wobei das zweite Unterstützungsglied (28) durch das Verschwenken der Bedieneinheit (100) derart einer Bewegung von der Öffnungsposition in die Verschlussposition folgt, dass zu Beginn der Bewegung des zweiten Unterstützungsglieds (28), das zweite Unterstützungsglied (28) in Bezug auf das erste Unterstützungsglied (24) verschwenkt wird, und zum Ende der Bewegung, das zweite Unterstützungsglied (28) linear in Richtung des ersten Unterstützungsglieds (24) bewegt wird,
dadurch charakterisiert, dass das zweite Unterstützungsglied (28) eine erste Kulissenführung (102) aufweist, in der ein erstes Nockenelement (104) der Bedieneinheit (100) führbar gelagert ist,
wobei die erste Kulissenführung (102) einen geschwungenen Abschnitt (106) und einen an dem geschwungenen Abschnitt anschließenden ersten linearen Abschnitt (108) aufweist, und
wobei beim Bewegen des zweiten Unterstützungsglieds (18) von der Öffnungsposition in die Verschlussposition, das erste Nockenelement (104) den geschwungenen Abschnitt (106) und den ersten linearen Abschnitt (108) entlanggeführt wird,
wobei die erste Kulissenführung (102) einen an dem ersten linearen Abschnitt (108) anschließenden zweiten linearen Abschnitt (110) aufweist, der ausgehend von dem ersten linearen Abschnitt (108) sich in Richtung des ersten Unterstützungsglieds (24) erstreckt,
wobei beim Bewegen des zweiten Unterstützungsglieds (28) von der Öffnungsposition in die Verschlussposition, das erste Nockenelement (104) den zweiten linearen Abschnitt (110) entlanggeführt wird, und
wobei durch Entlangführen des ersten Nockenelements (104) an dem ersten linearen Abschnitt (108) und dem zweiten linearen Abschnitt (110), die Bedieneinheit (100) das zweite Unterstützungsglied (28) in der Verschlussposition arretiert.

2. Verschließbares Grundmodul (14) nach Anspruch 1, wobei in der Verschlussposition die Bedieneinheit (100) durch das zweite Unterstützungsglied (28) arretiert ist.

3. Verschließbares Grundmodul (14) nach einem der vorangegangenen Ansprüche, wobei das zweite Unterstützungsglied (28) federnd an dem ersten Unterstützungsglied (24) gelagert ist.

4. Verschließbares Grundmodul (14) nach einem der vorangegangenen Ansprüche, wobei das zweite Unterstützungsglied (28) an einem Aufnahmepunkt (112) des ersten Unterstützungsglieds (24) verschwenkbar und gefedert angeordnet ist, und
wobei bevorzugt das zweite Unterstützungsglied (28) mittels eines Langlochs (114) an dem Aufnahmepunkt (112) des ersten Unterstützungsglieds (24) verschwenkbar in Bezug auf das erste Unterstützungsglied (24) gelagert ist, wobei das Langloch (114) ein Federelement (116) aufweist, welches derart auf den Aufnahmepunkt (112) wirkt, dass der Aufnahmepunkt (112) an einem Ende (118) des Langlochs (114) liegt.

5. Verschließbares Grundmodul (14) nach einem der vorangegangenen Ansprüche, wobei das zweite Unterstützungsglied (28) einen federgelagerten Anschlag (122) aufweist, der beim Bewegen des zweiten Unterstützungsglieds (28) von der Öffnungsposition in die Verschlussposition auf ein an dem ersten Unterstützungsglied (24) angeordneten Auflagerpunkt (124) geführt wird.

6. Verschließbares Grundmodul (14) nach Anspruch 5, sofern rückbezogen auf Anspruch 4, wobei beim linearen Bewegen des zweiten Unterstützungsglieds (28) in Richtung des ersten Unterstützungsglieds (24), der federgelagerte Anschlag (122) und das Federelement (116) des Langlochs (114) betätigt werden.

7. Verschließbares Grundmodul (14) nach einem der vorangegangenen Ansprüche, wobei das zweite Unterstützungsglied (28) eine zweite Kulissenführung (132) aufweist, in der ein zweites Nockenelement (134) der Bedieneinheit (100) führbar gelagert ist.

8. Verschließbares Grundmodul (14) nach einem der vorangegangenen Ansprüche, wobei das erste Unterstützungsglied (24) ein Federunterstützungselement (150) aufweist, welches mit dem zweiten Unterstützungsglied (28) verbunden ist, wobei das Federunterstützungselement (150) die Bewegung des zweiten Unterstützungsglieds (28) unterstützt.

9. Verschließbares Grundmodul (14) nach einem der vorangegangenen Ansprüche, wobei die Bedieneinheit (100) als Stanzblechbauteil oder Frästeil ausgebildet ist.

10. Modulares Testsystem (10) zum Testen elektrischer Baugruppen, aufweisend:
- ein verschließbares Grundmodul (14) nach einem der Ansprüche 1-9; und
- ein in dem Aufnahmeraum (26) anordenbares Testmodul (16).

11. Modulares Testsystem (10) nach Anspruch 10, weiter aufweisend ein an dem zweiten Unterstützungsglied (28) anordenbares Fixierungsmodul (22).

## Claims

1. A closable base module (14) for a modular test system (10) for testing electrical assemblies, comprising:
- a first support member (24) which provides a receiving space (26) for receiving a test module (16), wherein an electrical assembly to be tested can be arranged on the test module (16);
- a second support member (28) which is mounted so as to be pivotable relative to the first support member (24) and which is designed to receive a securing module (22) for securing the electrical assembly to be tested to the test module (16);
- an operating unit (100) which is pivotably mounted on the first support member (24) and which is guidably mounted on the second support member (28),
wherein, by pivoting the operating unit (100) with respect to the first support member (24), the second support member (28) can be moved into an open position, in which the electrical assembly to be tested is released by the securing module (22), and into a closed position, in which the electrical assembly to be tested is secured to the test module (16) by the securing module (22), and
wherein the second support member (28), due to the pivoting of the operating unit (100), follows a movement from the open position into the closed position in such a way that, at the start of the movement of the second support member (28), the second support member (28) is pivoted in relation to the first support member (24) and, at the end of the movement, the second support member (28) is moved linearly in the direction of the first support member (24),
**characterized in that** the second support member (28) comprises a first slotted guide (102) in which a first cam element (104) of the operating unit (100) is guidably mounted,
wherein the first slotted guide (102) comprises a curved portion (106) and a first linear portion (108) which follows on from the curved portion, and
wherein, when the second support member (18) moves from the open position into the closed position, the first cam element (104) is guided along the curved portion (106) and the first linear portion (108),
wherein the first slotted guide (102) comprises a second linear portion (110) which follows on from the first linear portion (108) and which extends in the direction of the first support member (24) proceeding from the first linear portion (108),
wherein, when the second support member (28) moves from the open position into the closed position, the first cam element (104) is guided along the second linear portion (110), and
wherein the operating unit (100) locks the second support member (28) in the closed position due to the first cam element (104) being guided along on the first linear portion (108) and the second linear portion (110).

2. The closable base module (14) according to claim 1, wherein the operating unit (100) is locked in the closed position by means of the second support member (28).

3. The closable base module (14) according to any one of the preceding claims, wherein the second support member (28) is spring-mounted on the first support member (24).

4. The closable base module (14) according to any one of the preceding claims, wherein the second support member (28) is arranged in a pivotable and springloaded manner at a receiving point (112) of the first support member (24), and wherein preferably the second support member (28) is mounted via an elongate hole (114) on the receiving point (112) of the first support member (24) so as to be pivotable in relation to the first support member (24), wherein the elongate hole (114) comprises a spring element (116) which acts on the receiving point (112) in such a way that the receiving point (112) is located at one end (118) of the elongate hole (114).

5. The closable base module (14) according to any one of the preceding claims, wherein the second support member (28) comprises a spring-mounted stop (122) which, when the second support member (28) moves from the open position into the closed position, is guided onto a bearing point (124) arranged on the first support member (24).

6. The closable base module (14) according to claim 5, as dependent on claim 4, wherein the spring-mounted stop (122) and the spring element (116) of the elongate hole (114) are actuated during the linear movement of the second support member (28) in the direction of the first support member (24).

7. The closable base module (14) according to any one of the preceding claims, wherein the second support member (28) comprises a second slotted guide (132) in which a second cam element (134) of the operating unit (100) is guidably mounted.

8. The closable base module (14) according to any one of the preceding claims, wherein the first support member (24) comprises a spring support element (150) which is connected to the second support member (28), wherein the spring support element (150) supports the movement of the second support member (28).

9. The closable base module (14) according to any one of the preceding claims, wherein the operating unit (100) is designed as a stamped sheet metal component or as a milled part.

10. A modular test system (10) for testing electrical assemblies, comprising:
- a closable base module (14) according to any one of claims 1 to 9; and
- a test module (16) that can be arranged in the receiving space (26).

11. The modular test system (10) according to claim 10, further comprising a securing module (22) that can be arranged on the second support member (28).

## Revendications

1. Module de base verrouillable (14) pour un système de test modulaire (10) permettant de tester des composants électriques, présentant :
- un premier organe de support (24) fournissant un espace de réception (26) destiné à recevoir un module de test (16), dans lequel un composant électrique à tester peut être agencé sur le module de test (16) ;
- un deuxième organe de support (28) monté de façon pivotante par rapport au premier organe de support (24), lequel est conçu pour recevoir un module de fixation (22) permettant de fixer le composant électrique à tester sur le module de test (16) ;
- une unité de commande (100) montée de façon pivotante sur le premier organe de support (24), laquelle est montée de manière à pouvoir être guidée sur le deuxième organe de support (28),
dans lequel, par pivotement de l'unité de commande (100) par rapport au premier organe de support (24), le deuxième organe de support (28) peut être déplacé dans une position d'ouverture dans laquelle le composant électrique à tester est libéré par le module de fixation (22), et dans une position de verrouillage dans laquelle le composant électrique à tester est fixé sur le module de test (16) par le module de fixation (22), et
dans lequel le deuxième organe de support (28) suit un déplacement de la position d'ouverture vers la position de verrouillage en raison du pivotement de l'unité de commande (100), de telle façon qu'au début du déplacement du deuxième organe de support (28), le deuxième organe de support (28) est pivoté par rapport au premier organe de support (24) et, à la fin du déplacement, le deuxième organe de support (28) est déplacé linéairement en direction du premier organe de support (24),
**caractérisé en ce que** le deuxième organe de support (28) présente un premier guide à coulisse (102), dans lequel un premier élément à came (104) de l'unité de commande (100) est monté de manière à pouvoir être guidé,
dans lequel le premier guide à coulisse (102) présente une section incurvée (106) et une première section linéaire (108) prolongeant la section incurvée, et
dans lequel, lors du déplacement du deuxième organe de support (18) de la position d'ouverture vers la position de verrouillage, le premier élément à came (104) est guidé le long de la section incurvée (106) et de la première section linéaire (108),
dans lequel le premier guide à coulisse (102) présente une deuxième section linéaire (110) prolongeant la première section linéaire (108), laquelle s'étend à partir de la première section linéaire (108) en direction du premier organe de support (24),
dans lequel, lors du déplacement du deuxième organe de support (28) de la position d'ouverture vers la position de verrouillage, le premier élément à came (104) est guidé le long de la deuxième section linéaire (110), et
dans lequel, par le guidage du premier élément à came (104) le long de la première section linéaire (108) et de la deuxième section linéaire (110), l'unité de commande (100) bloque le deuxième organe de support (28) dans la position de verrouillage.

2. Module de base verrouillable (14) selon la revendication 1, dans lequel, dans la position de verrouillage, l'unité de commande (100) est bloquée par le deuxième organe de support (28).

3. Module de base verrouillable (14) selon l'une des revendications précédentes, dans lequel le deuxième organe de support (28) est monté sur ressort au niveau du premier organe de support (24).

4. Module de base verrouillable (14) selon l'une des revendications précédentes, dans lequel le deuxième organe de support (28) est disposé de façon pivotante et sur ressort en un point de réception (112) du premier organe de support (24), et
dans lequel, de façon particulièrement préférée, le deuxième organe de support (28) est monté de façon à pouvoir pivoter par rapport au premier organe de support (24) au moyen d'un trou oblong (114) au niveau du point de réception (112) du premier organe de support (24), dans lequel le trou oblong (114) présente un élément de ressort (116), lequel agit de telle façon sur le point de réception (112), que le point de réception (112) se trouve à une extrémité (118) du trou oblong (114).

5. Module de base verrouillable (14) selon l'une des revendications précédentes, dans lequel le deuxième organe de support (28) présente une butée montée sur ressort (122), laquelle est guidée vers un point d'appui (124) disposé sur le premier organe de support (24) lors du déplacement du deuxième organe de support (28) de la position d'ouverture vers la position de verrouillage.

6. Module de base verrouillable (14) selon la revendication 5, dans la mesure où celle-ci dépend de la revendication 4, dans lequel, lors du déplacement linéaire du deuxième organe de support (28) en direction du premier organe de support (24), la butée montée sur ressort (122) et l'élément de ressort (116) du trou oblong (114) sont actionnés.

7. Module de base verrouillable (14) selon l'une des revendications précédentes, dans lequel le deuxième organe de support (28) présente un deuxième guide à coulisse (132), dans lequel un deuxième élément à came (134) de l'unité de commande (100) est monté de manière à pouvoir être guidé.

8. Module de base verrouillable (14) selon l'une des revendications précédentes, dans lequel le premier organe de support (24) présente un élément de support à ressort (150), lequel est relié au deuxième organe de support (28), dans lequel l'élément de support à ressort (150) supporte le déplacement du deuxième organe de support (28).

9. Module de base verrouillable (14) selon l'une des revendications précédentes, dans lequel l'unité de commande (100) est réalisée comme un composant en tôle perforée ou une pièce de fraisage.

10. Système de test modulaire (10) permettant de tester des composants électriques, présentant :
- un module de base verrouillable (14) selon l'une des revendications 1 à 9 ; et
- un module de test (16) apte à être agencé dans l'espace de réception (26).

11. Système de test modulaire (10) selon la revendication 10, présentant en outre un module de fixation (22) apte à être agencé sur le deuxième organe de support (28).
